# EUROPEAN PATENT APPLICATION

(11) **EP 4 835 580 A1**
(43) Date of publication of application: **04.11.2026**
(21) Application number: 26173305.9
(22) Date of filing: 20.04.2026
(51) Int. Cl.: G03F 7/32, G03F 7/42

(54) **WASHING LIQUID, METHOD FOR WASHING SUBSTRATE, AND METHOD FOR FORMING METAL-CONTAINING FILM**

(30) Priority: 30.04.2025 JP 2025075451
(71) Applicant: Shin-Etsu Chemical Co., Ltd., Tokyo 100-0005 (JP)
(72) Inventor: Iwamori, Shohei, Niigata (JP); Ujiie, Kenta, Niigata (JP); Kori, Daisuke, Niigata (JP); Nagamachi, Nobuhiro, Niigata (JP)
(74) Representative: Schicker, Silvia

(57) **Abstract**

The present invention is a washing liquid for a composition for forming a metal-containing film, the washing liquid including: (A) an organic acid; (B) a compound having two or more β-diketone structures in a molecule; and (C) a solvent. This can provide: a washing liquid having excellent washability such as removal of a metal-containing film on a circumferential edge of a substrate and having excellent drainage stability when a composition for forming a metal-containing film is applied onto the substrate; a method for washing a substrate using the above washing liquid; and a method for forming a metal-containing film using the above washing method.

## Description

### TECHNICAL FIELD

The present invention relates to a washing liquid for a composition for forming a metal-containing film that can be used in a fine processing step for a semiconductor device, etc., a method for washing a substrate, and a method for forming a metal-containing film.

### BACKGROUND ART

As higher integration and higher speed of LSI have been achieved, the pattern size has been rapidly miniaturized. With this miniaturization, lithography techniques have achieved formation of the fine pattern by shortening a wavelength of a light source and appropriately selecting a resist composition corresponding to the wavelength. The center of the resist composition is a positive-type photoresist composition used for a single layer. This single-layer positive-type photoresist composition has a skeleton having etching resistance against dry etching with chlorine-type or fluorine-type gas plasma in a resist resin, and has a switching mechanism so that an exposed portion is dissolved to form a pattern by dissolving the exposed portion. While using the remained resist pattern as an etching mask, a substrate to be processed is processed by dry etching.

However, miniaturing the pattern, that is reducing the pattern width, while keeping a film thickness of the photoresist film used causes a problem of deteriorating resolution performance of the photoresist film. In addition, pattern-developing such a photoresist film, which has an excessively high "aspect ratio", with a developer consequently causes a problem of pattern collapse. Thus, the photoresist film has been thinned as the pattern has been miniaturized.

Meanwhile, commonly used for processing a substrate to be processed is a method of processing the substrate by dry etching while using a photoresist film having a formed pattern as an etching mask. However, there is realistically no dry etching method that can have complete etching selectivity between the photoresist film and the substrate to be processed. Thus, there is a problem of collapse of the photoresist film with damaged during the substrate processing to fail to accurately transfer the resist pattern to the substrate to be processed. Accordingly, as the pattern has been miniaturized, the resist composition is required to have higher dry-etching resistance. However, on the other hand, a resin used for the photoresist composition is required to have small light absorption at the exposure wavelength to improve the resolution. Thus, as the wavelength of the exposure light has become shorter to i-line, KrF, and ArF, the resin has also changed to novolac resin, polyhydroxystyrene, and a resin having an aliphatic polycyclic skeleton. However, the etching rate under the dry etching condition during the substrate processing has become realistically high, and recent photoresist compositions having high resolution rather tend to have weak etching resistance.

Thus, the substrate to be processed is necessarily processed by dry etching with the photoresist film having a smaller thickness and weaker etching resistance. It is urgently necessary to achieve a material and process for this processing step.

One of methods to solve such a problem is a multilayer resist method. This method is of: interposing a resist middle film having etching selectivity different from etching selectivity of a photoresist film (that is, a resist upper layer film) between the resist upper layer film and a substrate to be processed; obtaining a pattern in the resist upper layer film; then transferring the pattern to the resist middle film by dry etching while using the resist upper layer film pattern as a dry etching mask; and further transferring the pattern to the substrate to be processed by dry etching while using the resist middle film as a dry etching mask.

One of the multilayer resist methods is a three-layer resist method that can be performed by using a common resist composition used for the single-layer resist method. In this three-layer resist method, for example, an organic film of novolac resin etc. is formed on a substrate to be processed as a resist underlayer film, a silicon-containing resist middle film is formed thereon as a resist middle film, and a common organic photoresist film is formed thereon as a resist upper layer film. The organic resist upper layer film can have good etching selectivity to the silicon-containing resist middle film when the dry etching is performed with fluorine-type gas plasma. Thus, the resist upper layer film pattern can be transferred to the silicon-containing resist middle film by dry etching with the fluorine-type gas plasma. According to this method, the pattern can be transferred to the silicon-containing resist middle film (the resist middle film) even by using a resist composition that is difficult to form a pattern having a film thickness sufficient for directly processing the substrate to be processed or by using a resist composition that has dry-etching resistance insufficient for processing the substrate. Subsequently transferring the pattern by dry etching with oxygen-type or hydrogen-type gas plasma can yield an organic film (resist underlayer film) pattern of the novolac resin, etc. that has dry-etching resistance sufficient for processing the substrate. As the aforementioned resist underlayer film, many materials including, for example, materials described in Patent Document 1, have been already known.

Meanwhile, fining of DRAM memories has been rapidly increased in recent years, and increased is a necessity of a resist underlayer film that has further improved dry-etching resistance and that has excellent embedding ability and planarizing ability. As the coating-type organic underlayer film material having excellent embedding ability and planarizing ability, materials described in Patent Document 2 have been reported, etc., for example. However, when focusing on application in the latest generation, the materials have concern about the dry-etching resistance, and the conventional coating-type organic underlayer film materials are approaching the application limit.

For the above object, development using a material containing a metal element in the resist underlayer film has been investigated. A baking treatment pyrolyzes a ligand coordinating to a metal in the composition for forming a metal-containing film, allows hydrolysis and condensation to form a metal oxide, and the resist underlayer film having excellent dry-etching resistance can be formed. Patent Document 3 reports that a material using a Ti compound exhibits excellent dry-etching resistance against CHF₃/CF₄-type gas and CO₂/N₂-type gas.

When the composition for forming a metal-containing film is used for the resist underlayer film, a metal compound may be bonded to a surface of a substrate such as a silicon wafer to generate a residue in applying the composition for forming a metal-containing film on the substrate. To remove such a residue, it has been proposed that a washing liquid containing an organic solvent and a carboxylic acid is used (Patent Document 4). In addition, Patent Document 5 proposes a washing liquid containing a solvent, an organic acid, and an additive that functions as a chelating agent.

Meanwhile, with considering practicability, drainage from a plurality of steps is discharged through the identical pipe in many cases when the aforementioned multilayer resist method is performed with one apparatus. The washing liquid is required to have drainage stability to inhibit an unintentional phenomenon such as precipitation of the metal in the pipe due to interference with other drainage.

### CITATION LIST

### PATENT DOCUMENTS

Patent Document 1: JP 2004-205685 A
Patent Document 2: JP 2017-119671 A
Patent Document 3: JP 2016-532739 A
Patent Document 4: JP 2019-532489 A
Patent Document 5: JP 2020-173361 A

### SUMMARY OF INVENTION

### TECHNICAL PROBLEM

The present invention has been made to solve the above problem. An object of the present invention is to provide: a washing liquid having excellent washability such as removal of a metal-containing film on a circumferential edge of a substrate and having excellent drainage stability when a composition for forming a metal-containing film is applied onto the substrate; a method for washing a substrate using the above washing liquid; and a method for forming a metal-containing film using the above washing method.

### SOLUTION TO PROBLEM

To achieve the above object, the present invention provides a washing liquid for a composition for forming a metal-containing film, the washing liquid comprising:
(A) an organic acid;
(B) a compound having two or more β-diketone structures in a molecule; and
(C) a solvent.

With the washing liquid as above, the compound (B) has two or more β-diketone structures in a molecule, and thus, a bidentate chelating effect due to the β-diketone structure contained as a partial structure from microperspective and a tetradentate or higher, stronger chelating effect due to a plurality of the β-diketone structures from macro-perspective can be exhibited. Therefore, metal removability of the washing liquid can be improved.

In addition, the compound (B) preferably has a structure represented by the following general formula (B-1): 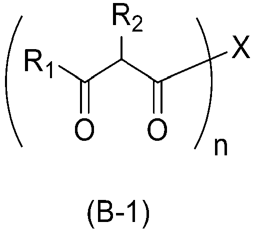 wherein R₁ and R₂ represent a hydrogen atom, a monovalent organic group having 1 to 30 carbon atoms, a thiol group, a hydroxy group, an amino group, a carboxy group, or a halogen atom; X represents an n-valent organic group having 1 to 60 carbon atoms; and "n" represents an integer of 2 to 6.

The washing liquid containing the compound (B) as above can further improve the metal removability and the drainage stability.

In addition, the compound (B) preferably has a structure represented by the following general formula (B-0a) : 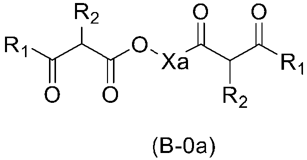
wherein, it is preferable that R₁ and R₂ represent a hydrogen atom, a monovalent organic group having 1 to 30 carbon atoms, a thiol group, a hydroxy group, an amino group, a carboxy group, or a halogen atom; and Xa represents a structure represented by the following general formula (B-1a):

   **Xₐ= *¹-W-O-*²** **(B-1a)**
wherein W represents a divalent organic group, "*¹" represents a point of attachment to an oxygen atom, and **"*²"** represents a point of attachment to a carbonyl carbon atom in the β-diketone.

The washing liquid containing the compound (B) as above can further improve the metal removability and the drainage stability.

In addition, Xa in the general formula (B-0a) preferably represents a structure represented by the following general formula (B-2a): 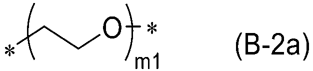 wherein "m₁" represents an average number of repeating units, and represents 1 to 10, and "*" represents a point of attachment.

The washing liquid containing the compound (B) as above can furthermore improve the metal removability and the drainage stability.

In addition, the solvent (C) preferably contains at least one or more solvents selected from the group consisting of a ketone solvent and an ester solvent.

Using the solvent as above can improve stability with time of the washing liquid.

In addition, the organic acid (A) is preferably a carboxylic acid.

The washing liquid containing the carboxylic acid as the organic acid can further improve the metal removability.

In addition, a content of the compound (B) is preferably 0.1 to 10 mass% relative to a total mass of the washing liquid.

Regulating the content of the compound (B) contained in the washing liquid to be within the above range can further improve the metal removability, the stability with time of the washing liquid, and the drainage stability.

In addition, a content of the organic acid (A) is preferably 0.5 to 80 mass% relative to a total mass of the washing liquid.

Regulating the content of the organic acid contained in the washing liquid to be within the above range can further improve the metal removability, the stability with time of the washing liquid, and the drainage stability.

In addition, the present invention provides a method for washing a substrate, the method comprising: a step of applying a composition for forming a metal-containing film directly or indirectly onto a substrate; and a step of washing the substrate with the washing liquid of the present invention.

The method for washing a substrate as above can reduce metal residue generated on the substrate when the composition for forming a metal-containing film is applied.

In addition, the present invention provides a method for forming a metal-containing film, the method comprising: a step of applying a composition for forming a metal-containing film directly or indirectly onto a substrate by using a composition containing a metal compound (M) and a solvent (D) as the composition for forming a metal-containing film; and a step of washing a circumferential edge of the substrate with the washing liquid of the present invention.

The method for forming a metal-containing film as above can reduce metal residue generated on the substrate when the composition for forming a metal-containing film is applied. Therefore, the method can be suitably used in a step of forming a metal-containing film by using the composition for forming a metal-containing film.

### ADVANTAGEOUS EFFECTS OF INVENTION

As described above, the washing liquid of the present invention contains: (A) the organic acid; (B) the compound having two or more β-diketone structures in a molecule; and (C) the solvent. Thus, the present invention can provide the washing liquid having excellent washability such as removal of the metal-containing film on a circumferential edge of the substrate and having excellent drainage stability when the composition for forming a metal-containing film is applied onto the substrate. Further, the method for washing a substrate and the method for forming a metal-containing film using this washing liquid can use the washing liquid having excellent washability and drainage stability, and can consequently inhibit troubles such as contamination of an apparatus and can efficiently form a desired resist underlayer film without decrease in productivity. These can be suitably used for manufacturing semiconductor devices, etc. in which further fining is expected to proceed in future.

### BRIEF DESCRIPTION OF DRAWINGS

FIG. 1 is a flow view of an example in which a metal-containing film is formed on a substrate, and the film on an outer circumferential end is removed with the washing liquid of the present invention;
FIG. 2 is a flow view of an example in which a metal-containing film is formed on a substrate, and the metal-containing film is peeled with the washing liquid of the present invention; and
FIG. 3 is a flow view of an example of the method for forming a metal-containing film of the present invention.

### DESCRIPTION OF EMBODIMENTS

In a manufacturing step for semiconductor devices, etc., one of treatments performed in a step of forming a metal-containing film pattern is an edge bead removal (EBR) treatment of supplying a solvent to a substrate in which a metal-containing film is formed on its surface and removing an unnecessary film on a circumferential edge of the coating film in a ring shape. This EBR treatment is performed by locally discharging a washing liquid to the circumferential edge of the rotating substrate through a solvent nozzle.

The EBR treatment for the metal-containing film has required: a washing liquid having excellent metal washability such as removal of the metal-containing film on the circumferential edge of the substrate when the composition for forming a metal-containing film is applied onto the substrate and having excellent stability when mixed with other drainage; a method for washing a semiconductor substrate using this washing liquid; and a method for forming a metal-containing film using this washing method.

In conventional art, a washing liquid containing an organic solvent and a carboxylic acid is used for removing the metal-containing film, but there has been room for improvement of the metal removability.

The present inventors have intensively investigated the above problem, and consequently found that the above problem can be solved by a washing liquid containing a compound having two or more β-diketone structures in a molecule (B). This finding has led to completion of the present invention.

Specifically, the present invention is a washing liquid for a composition for forming a metal-containing film, the washing liquid containing:
(A) an organic acid;
(B) a compound having two or more β-diketone structures in a molecule; and
(C) a solvent.

Hereinafter, the present invention will be described in detail, but the present invention is not limited thereto.

### <Washing liquid>

The washing liquid of the present invention is a washing liquid for a composition for forming a metal-containing film, the washing liquid containing: (A) an organic acid; (B) a compound having two or more β-diketone structures in a molecule; and (C) a solvent. The washing liquid of the present invention is used for washing a substrate on which a composition for forming a metal-containing film is applied.

### [(A) Organic acid]

The washing liquid of the present invention contains the organic acid (A). Adding the organic acid into the washing liquid improves the removability of the metal-containing film formed on the substrate.

Examples of the organic acid include carboxylic acids, sulfonic acids, sulfinic acids, organic phosphinic acids, organic phosphonic acids, phenols, enols, thiols, acid imides, oximes, and sulfonamides.

The organic acid is preferably a sulfonic acid or a carboxylic acid, and more preferably a carboxylic acid. Specific examples of the sulfonic acid include methanesulfonic acid, ethanesulfonic acid, N-(2-acetamide)-2-aminoethanesulfonic acid, morpholinoethanesulfonic acid, amidinothiopropanesulfonic acid, 2-acrylamide-2-methylpropanesulfonic acid, N,N-bis(2-hydroxyethyl)-2-aminoethanesulfonic acid, 2-hydroxy-3-morpholinopropanesulfonic acid, camphorsulfonic acid, 3-(cyclohexylamino)-2-hydroxypropane-1-sulfonic acid, 2-[4-(2-hydroxyethyl)-1-piperadinyl]ethanesulfonic acid, benzenesulfonic acid, pyridinesulfonic acid, aminobenzenesulfonic acid, hydroxybenzenesulfonic acid, hydroxypyridinesulfonic acid, xylenesulfonic acid, pyridylethanesulfonic acid, toluidinesulfonic acid, diaminobenzenesulfonic acid, hydrazinobenzenesulfonic acid, aminophenolsulfonic acid, chlorobenzenesulfonic acid, aminodimethylbenzenesulfonic acid, aminomethoxybenzenesulfonic acid, chloroanilinesulfonic acid, naphthalenesulfonic acid, sulfoisoquinoline, 3-cyclohexylaminopropanesulfonic acid, aminochlorotoluenesulfonic acid, aminonaphthalenesulfonic acid, aminochlorophenolsulfonic acid, diaminotrimethylbenzenesulfonic acid, aminonaphtholsulfonic acid, dichloroanilinesulfonic acid, hydroquinolinesulfonic acid, dimethylaminosulfonic acid, ethoxyquinolinesulfonic acid, trichlorobenzenesulfonic acid, iodobenzenesulfonic acid, anilinonaphthalenesulfonic acid, nonafluoro-1-butanesulfonic acid, hydroxymethoxybenzophenonesulfonic acid, lumogallion, hydroxyiodoquinolinesulfonic acid, calmagite, naphthalenedisulfonic acid, dimethylsulfonazo III, vinylsulfonic acid, aminomethanesulfonic acid, hydroxylamine-O-sulfonic acid, aminoethanesulfonic acid, aminopropanesulfonic acid, chlorosulfonic acid, and trifluoromethanesulfonic acid.

Specific examples of the carboxylic acid include: carboxylic acids composed of an aliphatic saturated hydrocarbon group and/or an aromatic hydrocarbon group and a carboxy group, such as formic acid, acetic acid, propionic acid, butanoic acid (butyric acid), isobutanoic acid (isobutyric acid), pentanoic acid, hexanoic acid, 2-ethylhexanoic acid, cyclohexanecarboxylic acid, cyclohexylacetic acid, 1-adamantanecarboxylic acid, benzoic acid, and phenylacetic acid; fluorine-atom-containing monocarboxylic acids such as difluoroacetic acid, trifluoroacetic acid, pentafluoropropanoic acid, heptafluorobutanoic acid, fluorophenylacetic acid, and difluorobenzoic acid; monocarboxylic acids having a group containing a heteroatom other than a fluorine atom in a portion other than the carboxy group, such as 10-hydroxydecanoic acid, 5-oxohexanoic acid, 3-methoxycyclohexanecarboxylic acid, camphorcarboxylic acid, dinitrobenzoic acid, nitrophenylacetic acid, lactic acid, glycolic acid, glyceric acid, salicylic acid, anisic acid, gallic acid, and furancarboxylic acid; unsaturated monocarboxylic acids such as acrylic acid, methacrylic acid, crotonic acid, isocrotonic acid, 3-butenoic acid, angelic acid, tiglic acid, 4-pentenoic acid, cinnamic acid, sorbic acid, propiolic acid, and 2-butynic acid; polycarboxylic acids composed of a single bond, an aliphatic saturated hydrocarbon group and/or an aromatic hydrocarbon group, and a plurality of carboxy groups, such as oxalic acid, malonic acid, succinic acid, glutaric acid, adipic acid, dodecanedicarboxylic acid, propanetricarboxylic acid, butanetetracarboxylic acid, cyclohexanehexacarboxylic acid, 1,4-naphthalenedicarboxylic acid, phthalic acid, isophthalic acid, terephthalic acid, trimellitic acid, pyromellitic acid, and 1,2,3,4-cyclobutanetetracarboxylic acid; partially esterified compounds of the above polycarboxylic acids; fluorine-atom-containing polycarboxylic acids such as difluoromalonic acid, tetrafluorophthalic acid, and hexafluoroglutaric acid; polycarboxylic acids having a heteroatom other than a fluorine atom in a portion other than the carboxy group, such as tartaric acid, citric acid, malic acid, tartronic acid, diglycolic acid, and iminodiacetic acid; and unsaturated polycarboxylic acids such as maleic acid, fumaric acid, and aconitic acid.

The organic acid is further preferably at least one selected from the group consisting of formic acid, acetic acid, citric acid, oxalic acid, 2-ethylhexanoic acid, dodecanoic acid, ascorbic acid, tartaric acid, glucuronic acid, acrylic acid, methacrylic acid, crotonic acid, isocrotonic acid, 3-butenoic acid, and methanesulfonic acid in terms of the washability and the drainage stability.

A lower limit of a content rate of the organic acid in all the components contained in this washing liquid is preferably 0.5 mass%, more preferably 1 mass%, further preferably 2 mass%, and particularly preferably 3 mass%. An upper limit of the content rate is preferably 80 mass%, more preferably 70 mass%, further preferably 65 mass%, and particularly preferably 60 mass%. Setting the content rate of the organic acid to be within the above range can further improve the washability and the drainage stability.

### [(B) Compound]

The washing liquid of the present invention contains a compound having two or more β-diketone structures in a molecule (B). The compound (B) has two or more β-diketone structures in a molecule, and thus, a bidentate chelating effect due to the β-diketone structure contained as a partial structure from microperspective and a tetradentate or higher, stronger chelating effect due to a plurality of the β-diketone structures from macro-perspective can be exhibited. Therefore, the metal removability and the drainage stability of the washing liquid can be improved.

The compound (B) preferably has a structure represented by the following general formula (B-1): 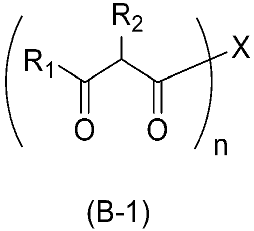 wherein R₁ and R₂ represent a hydrogen atom, a monovalent organic group having 1 to 30 carbon atoms, a thiol group, a hydroxy group, an amino group, a carboxy group, or a halogen atom; X represents an n-valent organic group having 1 to 60 carbon atoms; and "n" represents an integer of 2 to 6.

Since functioning as a chelating agent, the compound (B) as above can improve washability such as removal of the metal-containing film on the circumferential edge of the substrate when the composition for forming a metal-containing film is applied onto the substrate.

In the general formula (B-1), R₁ preferably represents a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having one or more double bonds or triple bonds and 2 to 30 carbon atoms, a substituted or unsubstituted alkoxy group having 1 to 30 carbon atoms, a substituted or unsubstituted hetero-alkyl group having 1 to 30 carbon atoms, a substituted or unsubstituted aryl group having 6 to 30 carbon atoms, a thiol group, a hydroxy group, an amino group, a carboxy group, or a halogen atom, more preferably a methyl group or a substituted or unsubstituted alkoxy group having 1 to 30 carbon atoms from the viewpoints of raw material availability, the metal removability, and the drainage stability, and further preferably a methyl group or a substituted or unsubstituted alkoxy group having 1 to 10 carbon atoms. Specific examples of the alkoxy group having 1 to 30 carbon atoms include the following structures.

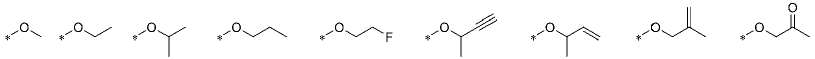

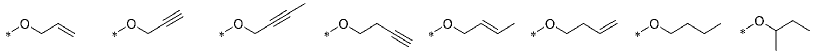

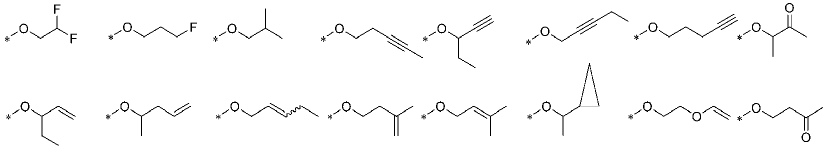

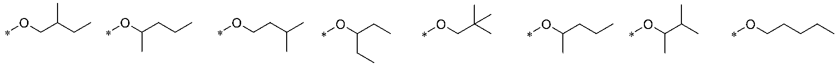

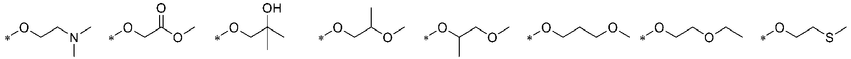

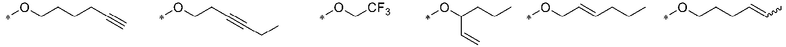

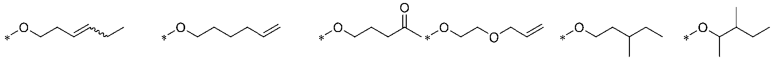

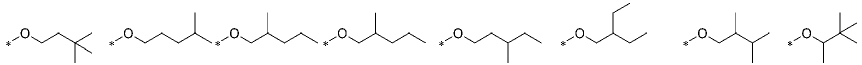

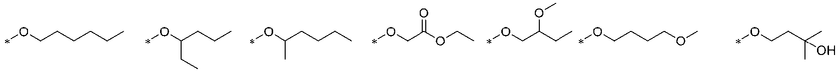

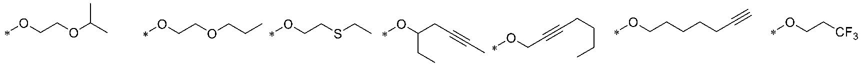

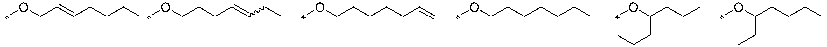

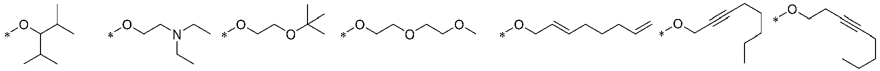

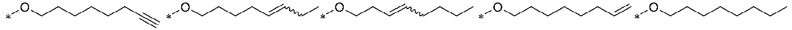

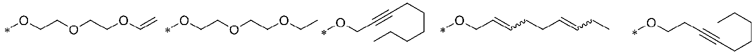

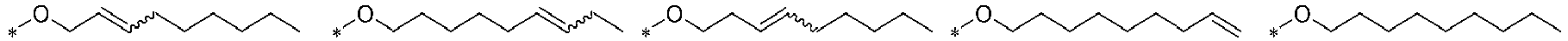

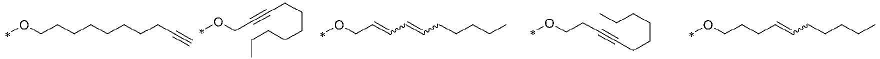

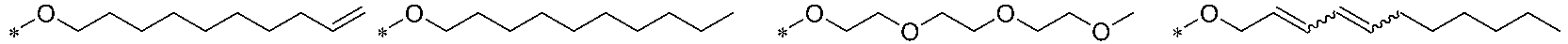

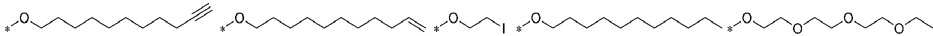

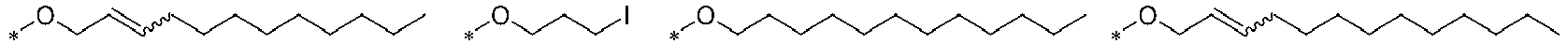

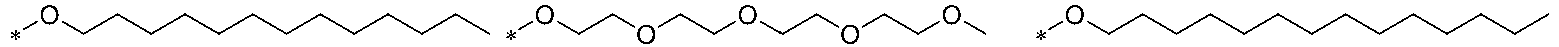

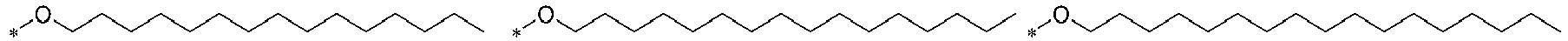

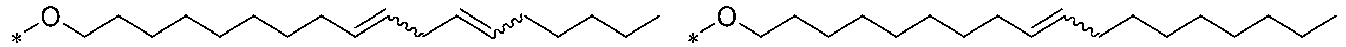

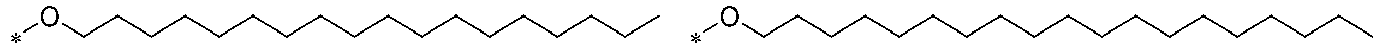

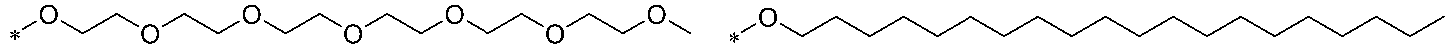

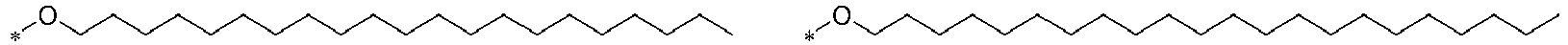

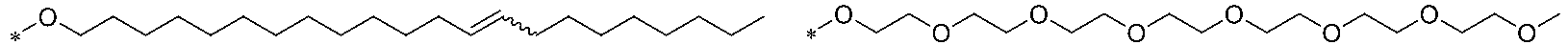

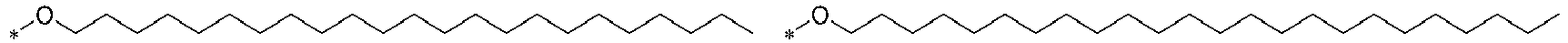

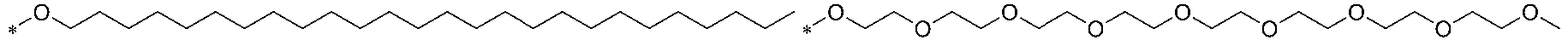

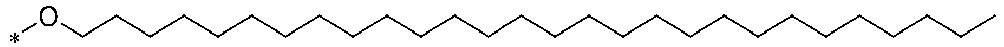

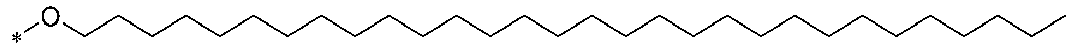

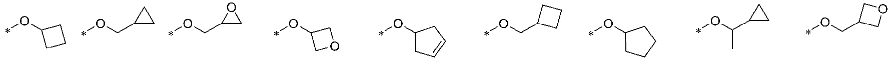

In the general formula (B-1), R₂ preferably represents a hydrogen atom, a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having one or more double bonds or triple bonds and 2 to 30 carbon atoms, a substituted or unsubstituted alkoxy group having 1 to 30 carbon atoms, a substituted or unsubstituted hetero-alkyl group having 1 to 30 carbon atoms, a substituted or unsubstituted aryl group having 6 to 30 carbon atoms, a thiol group, a hydroxy group, an amino group, a carboxy group, or a halogen atom, and specific examples thereof include the following structures. R₂ more preferably represents a hydrogen atom, a substituted or unsubstituted saturated alkyl group having 1 to 10 carbon atoms, or a substituted or unsubstituted hetero-alkyl group having 1 to 10 carbon atoms from the viewpoints of raw material availability, the metal removability, and the drainage stability.

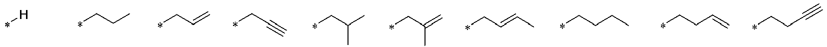

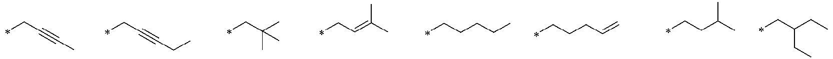

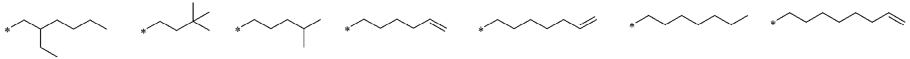

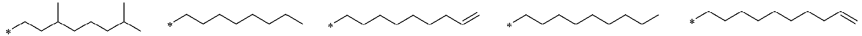

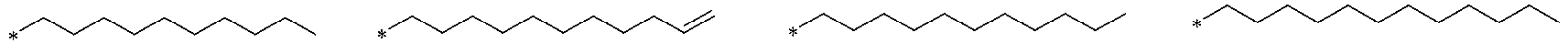

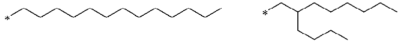

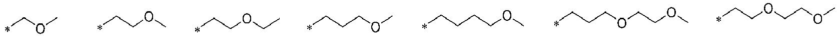

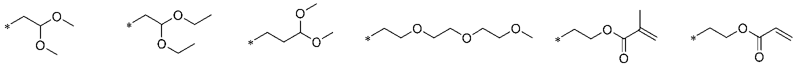

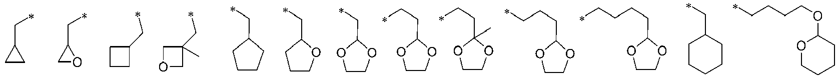

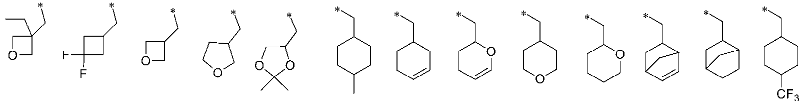

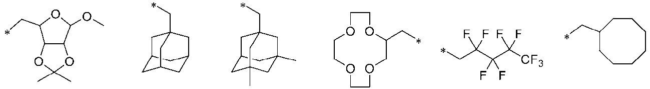

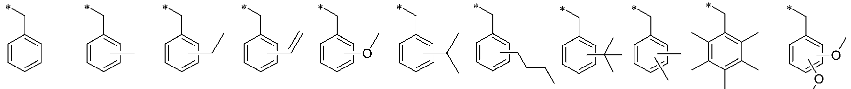

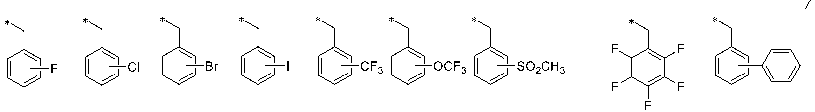

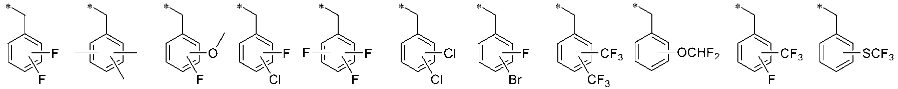

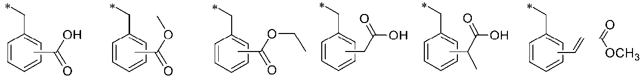

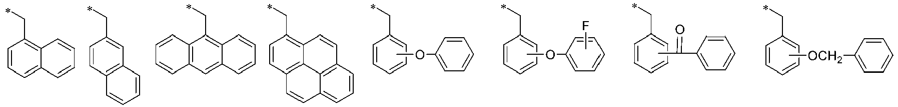

In the general formula (B-1), X represents an n-valent organic group having 1 to 60 carbon atoms, and preferably an n-valent substituted or unsubstituted linear alkyl group having 1 to 30 carbon atoms, a substituted or unsubstituted branched or cyclic alkyl group having 3 to 30 carbon atoms, a substituted or unsubstituted aliphatic unsaturated organic group having one or more double bonds or triple bonds and 2 to 30 carbon atoms, a substituted or unsubstituted ketone group having 1 to 30 carbon atoms, a substituted or unsubstituted ether group having 1 to 30 carbon atoms, a substituted or unsubstituted ester group having 1 to 30 carbon atoms, a substituted or unsubstituted amide group having 1 to 30 carbon atoms, a substituted or unsubstituted imine group having 1 to 30 carbon atoms, a substituted or unsubstituted aryl group having 6 to 30 carbon atoms, a substituted or unsubstituted arylalkyl group having 6 to 30 carbon atoms, or a substituted or unsubstituted saturated or unsaturated hydrocarbon group having 2 to 30 carbon atoms that is to form a cyclic structure together with a substituted or unsubstituted triazine ring or a 2×n-valent aromatic ring. "n" represents an integer of 2 to 6, preferably 2 to 4 from the viewpoint of raw material availability and the metal removability, and more preferably 2 from the viewpoint of the drainage stability.

Specific examples of the general formula (B-1) include, but are not limited to, the following formulae: 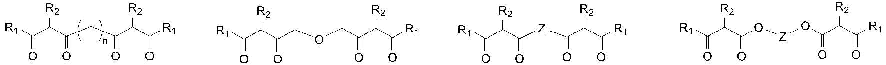 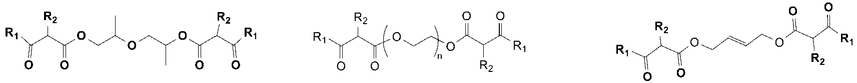 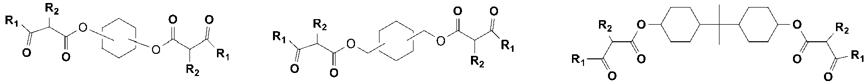 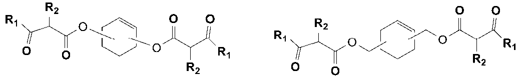 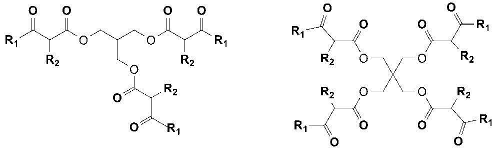 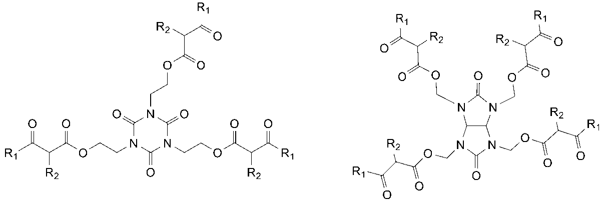 wherein Z represents any of a substituted or unsubstituted alkyl group having 1 to 30 carbon atoms, a substituted or unsubstituted branched or cyclic alkyl group having 3 to 30 carbon atoms, and a substituted or unsubstituted aliphatic unsaturated organic group having one or more double bonds or triple bonds and 2 to 30 carbon atoms. In the formulae, R₁ and R₂ are the same as above.

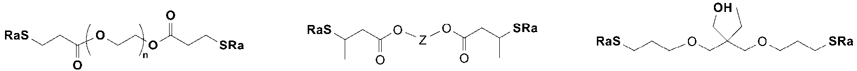

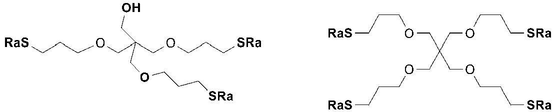

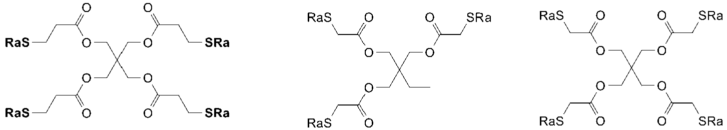

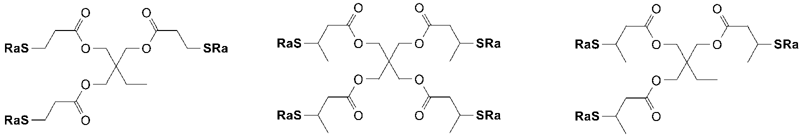

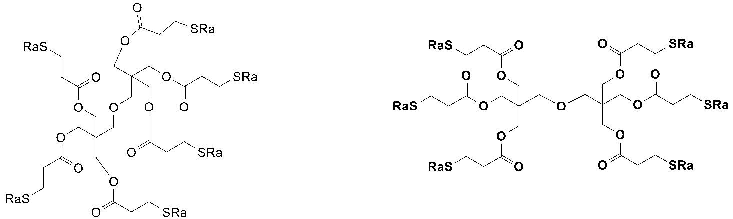

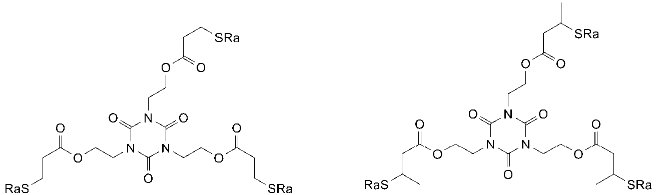

In the formulae, Z represents any of a substituted or unsubstituted alkyl group having 1 to 30 carbon atoms, a substituted or unsubstituted branched or cyclic alkyl group having 3 to 30 carbon atoms, and a substituted or unsubstituted aliphatic unsaturated organic group having one or more double bonds or triple bonds and 2 to 30 carbon atoms; and Rₐ is any one of the following formulae: 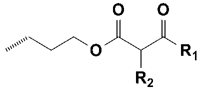 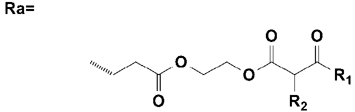 wherein a broken line represents a bond to the S atom. R₁ and R₂ are the same as above.

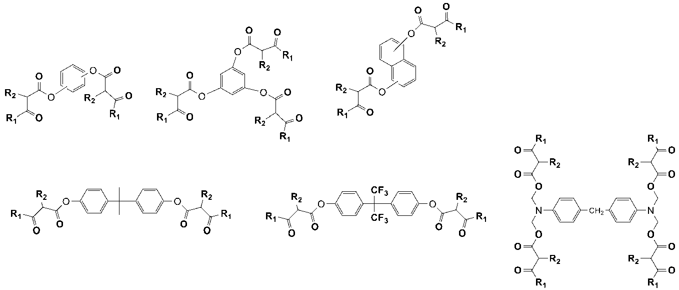

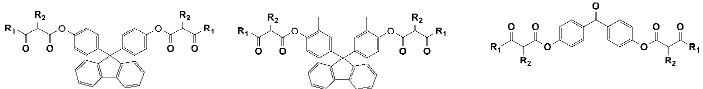

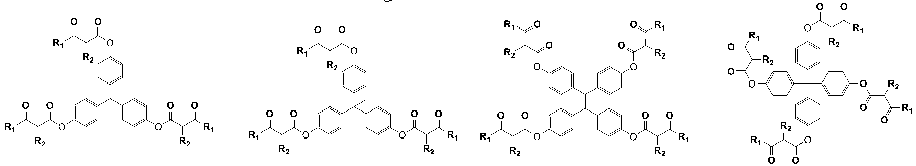

In the formulae, R₁ and R₂ are the same as above.

Examples of more preferable structures of the general formula (B-1) include structures represented by the following formula (B-0a): 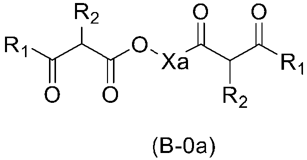
wherein R₁ and R₂ represent a hydrogen atom, a monovalent organic group having 1 to 30 carbon atoms, a thiol group, a hydroxy group, an amino group, a carboxy group, or a halogen atom; and Xa represents a structure represented by the following general formula (B-1a):

   Xa= *¹-W-O-*² (B-1a)
wherein W represents a divalent organic group, "*¹" represents a point of attachment to an oxygen atom, and "*²" represents a point of attachment to a carbonyl carbon atom in the β-diketone structure.

The washing liquid containing the compound as above can provide the washing liquid having excellent metal washability such as removal of the metal-containing film on the circumferential edge of the substrate when the composition for forming a metal-containing film is applied onto the substrate and having excellent stability when mixed with other drainage.

W in the general formula (B-1a) preferably represents any of a substituted or unsubstituted alkyl group having 1 to 30 carbon atoms, a substituted or unsubstituted branched or cyclic alkyl group having 3 to 30 carbon atoms, a substituted or unsubstituted aliphatic unsaturated organic group having one or more double bonds or triple bonds and 2 to 30 carbon atoms, a substituted or unsubstituted hetero-alkyl group having 1 to 30 carbon atoms, and a substituted or unsubstituted aryl group having 6 to 30 carbon atoms, and more preferably a substituted or unsubstituted alkyl group having 1 to 30 carbon atoms or a substituted or unsubstituted hetero-alkyl group having 1 to 30 carbon atoms from the viewpoint of raw material availability.

In addition, Xa in the general formula (B-0a) preferably represents a structure represented by the following general formula (B-2a) from the viewpoints of the metal removability and the drainage stability: 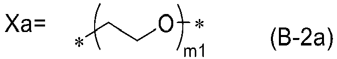 wherein "m₁" represents an average number of repeating units, and represents 1 to 10, and "*" represents a point of attachment.

The compound having the structure as above further improves the metal washability such as removal of the metal-containing film and stability when mixed with other drainage.

A content of the compound (B) is preferably 0.1 to 10 mass% relative to the total mass of the washing liquid.

### [(C) Solvent]

Examples of the solvent (C) contained in the washing liquid of the present invention include, but are not limited to, water and an organic solvent.

Examples of the organic solvent include: glycol ethers and esters thereof such as propylene glycol methyl ether (PGME), propylene glycol ethyl ether (PGEE), propylene glycol propyl ether (PGPE), propylene glycol butyl ether (PGBE), propylene glycol methyl ether acetate (PGMEA), and ethylene glycol methyl ether; alcohols such as ethanol, propanol, isopropyl alcohol, isobutyl alcohol, hexanol, ethylene glycol, and propylene glycol; cyclic esters such as γ-butyrolactone; esters such as n-butyl acetate and ethyl acetate; ketones such as 2-heptanone, cyclopentanone, and cyclohexanone; liquid cyclic carbonates such as propylene carbonate and butylene carbonate; and cyclic sulfones such as sulfolane.

Among these, the solvent is preferably glycol ethers, esters of the glycol ethers, or ketones, and preferably propylene glycol methyl ether (PGME), propylene glycol ethyl ether (PGEE), propylene glycol monopropyl ether (PGPE), propylene glycol methyl ether acetate (PGMEA), 2-heptanone, cyclopentanone, or cyclohexanone. Further, an organic solvent having no hydroxy group is preferable, and at least one or more solvents selected from the group consisting of the ketone solvent and the ester solvent is further preferably contained. Specifically, the esters of the glycol ethers or linear ketones are more preferable, and propylene glycol methyl ether acetate (PGMEA) and 2-heptanone are more preferable.

Using the organic solvent having no hydroxy group can inhibit an esterification reaction with the organic acid contained in the washing liquid during storage.

In the present embodiment, the solvent may be used singly, or may be used as a mixed solvent of two or more thereof. As for the washing liquid according to the present embodiment, a lower limit of a content of the solvent is preferably 20 mass% or more, more preferably 30 mass% or more, and further preferably 35 mass% or more relative to the total mass of the washing liquid. An upper limit of the content of the solvent is preferably 99 mass% or less, more preferably 98 mass% or less, and further preferably 95 mass% or less relative to the total mass of the washing liquid.

### [Other components]

The washing liquid according to the present aspect may contain other components in addition to the above components according to the object of the present invention. Examples of the other components include an inorganic fluorine-containing acid, a tetraalkylammonium compound, and a surfactant. Examples of the inorganic fluorine-containing acid include hexafluorosilicic acid, hexafluorophosphoric acid, and fluoroboric acid. Examples of the tetraalkylammonium compound include tetramethylammonium fluoride, tetrabutylammonium fluoride, and tetrabutylammonium fluorosilicate. As the surfactant, those described in paragraphs [0142] to [0147] in JP 2009-269953 A may be used, for example. The additives may be used singly, or may be used in combination of two or more thereof. In the washing liquid according to the present embodiment, a content of the additive (the other components) is preferably 0 to 10 mass% relative to the total mass of the washing liquid.

### <Method for preparing washing liquid>

The washing liquid of the present invention can be prepared by mixing the organic acid (A), the compound having two or more β-diketone structures in a molecule (B), the solvent (C), and the organic acid or the optional component as necessary at a predetermined ratio, and filtering the obtained mixture with a filter having a pore diameter of 0.5 µm or less, etc. A smaller pore diameter of the filter is more preferable from the viewpoints of foreign matter removal and a metal impurity contained in the raw materials for the washing liquid. The pore diameter of the filter is preferably 0.1 µm or less, and more preferably 0.05 µm or less. A base material for the filter used in this case, namely a material to constitute the filter, is preferably those that elutes no metal. Examples of such a material include nylon, polyethylene, polypropylene, polystyrene, and fluororesin. These base materials may be each used singly, may be used in combination, or may be uniformized base materials, so-called polymer alloy structure.

### <Method for washing substrate>

The washing liquid of the present invention can be used for removing the composition for forming a metal-containing film on the circumferential edge of the substrate when the composition for forming a metal-containing film is applied onto the substrate, etc.

The method for washing a substrate of the present invention includes: a step of applying a composition for forming a metal-containing film directly or indirectly onto a substrate; and a step of washing the substrate with the washing liquid described above.

When the composition for forming a metal-containing film is a material for a resist underlayer film, the method preferably further includes: a step (a resist-pattern-forming step) of forming a photoresist film directly or indirectly on the metal-containing film formed by the applying step, after the washing step; a step of exposing the photoresist film; a step of forming a photoresist pattern by development; and a step of transferring the resist pattern directly or indirectly on the metal-containing film by etching while using the resist pattern as a mask.

When the composition for forming a metal-containing film is a material for a photoresist film, the method preferably includes: a step of exposing the photoresist film; a step of forming a photoresist pattern by development; and a step of transferring the resist pattern directly or indirectly on the substrate by etching while using the resist pattern as a mask.

The circumferential edge of the substrate refers to, for example, an outer circumferential portion of the substrate having a length from the outer circumferential end of the substrate to the center of the substrate of within 3.0 cm. The length from the outer circumferential end of the substrate to the center of the substrate may be 2.0 cm, 1.0 cm, 0.5 cm, or 0.2 cm.

When the composition for forming a metal-containing film is a material for a resist underlayer film, the method for manufacturing a semiconductor substrate may further include, as necessary, a step (an organicresist-underlayer-film-forming step) of forming an organic resist underlayer film directly or indirectly on the substrate having the metal-containing film formed by the above applying step before the resist-pattern-forming step.

When the composition for forming a metal-containing film is a material for a resist underlayer film, the method for manufacturing a semiconductor substrate may further include, as necessary, a step (a silicon-containing-film-forming step) of forming a silicon-containing film directly or indirectly on the substrate having the metal-containing film formed by the above applying step before the resist-pattern-forming step.

Hereinafter, described are the composition for forming a metal-containing film and the washing liquid used for the method for manufacturing a semiconductor substrate, as well as each of the steps when the method includes the organic-underlayer-film-forming step and the silicon-containing-film-forming step, which are the optional steps.

### <Composition for forming metal-containing film>

The composition for forming a metal-containing film for which the washing liquid of the present invention can be applied is not particularly limited as long as it contains a metal compound (M) and a solvent (D). The composition for forming a metal-containing film may contain other optional components according to the object. The composition for forming a metal-containing film is preferably a material usable as the photoresist film or the resist underlayer film.

The metal compound (M) is preferably a compound having a metal atom and an oxygen atom. Examples of the metal atom to constitute the metal compound (M) include the group 3 to group 16 metal atoms in the periodic table (provided that, except for a silicon atom). The metal compound (M) may have one type or two or more types of the metal atom.

Examples of the metal atom to constitute the metal compound (M) include:
scandium, yttrium, lanthanum, and cerium as the group 3 metal atom;
titanium, zirconium, and hafnium as the group 4 metal atom;
vanadium, niobium, and tantalum as the group 5 metal atom;
chromium, molybdenum, and tungsten as the group 6 metal atom;
manganese and rhenium as the group 7 metal atom;
iron, ruthenium, and osmium as the group 8 metal atom;
cobalt, rhodium, and iridium as the group 9 metal atom;
nickel, palladium, and platinum as the group 10 metal atom;
copper, silver, and gold as the group 11 metal atom;
zinc, cadmium, and mercury as the group 12 metal atom;
aluminum, gallium, and indium as the group 13 metal atom;
germanium, tin, and lead as the group 14 metal atom;
antimony and bismuth as the group 15 metal atom; and
tellurium as the group 16 metal atom.

The metal atom to constitute the compound (M) is preferably the group 3 to group 16 metal atoms, more preferably the group 4 to group 14 metal atoms, further preferably the group 4, group 5, and group 14 metal atoms, and particularly preferably the group 4 metal atom. Specifically, titanium, chromium, manganese, iron, cobalt, nickel, copper, zinc, zirconium, molybdenum, indium, tin, hafnium, tantalum, tungsten, and bismuth, or a combination thereof are preferable.

A component other than the metal atom to constitute the metal compound (M) (hereinafter, also referred to as "compound [X]") preferably has one or more hydrolysable groups or ligands derived from a compound including an organic acid (hereinafter, also referred to as "organic acid (a)"), a hydroxy acid ester, a β-diketone, a β-diketoester, an amine, an amide, an olefin, a hydrocarbon having a π-bond, and a diphosphine. Here, "organic acid" refers to an organic compound that exhibits acidity, and "organic compound" refers to a compound having at least one carbon atom. A containing form of the organic acid (a) includes an organic acid anion in which a hydrogen ion is removed from the organic acid (a).

Examples of the hydrolysable group include a halogen atom, an alkoxy group, and an acyloxy group.

Examples of the halogen atom include a fluorine atom, a chlorine atom, a bromine atom, and an iodine atom.

The alkoxy group is preferably an alkoxy group having 1 to 10 carbon atoms, and examples thereof include a methoxy group, an ethoxy group, a n-propoxy group, an i-propoxy group, a butoxy group, and an octyloxy group.

Examples of the acyloxy group include an acetoxy group, an ethylyloxy group, a propionyloxy group, a butylyloxy group, a t-butylyloxy group, a t-amylyloxy group, a n-hexanecarbonyloxy group, and a n-octanecarbonyloxy group.

The hydrolysable group is preferably an alkoxy group and an acyloxy group, and more preferably a n-propoxy group, an i-propoxy group, a butoxy group, or an octyloxy group.

Examples of the organic acid (a) include carboxylic acids, sulfonic acids, sulfinic acids, organic phosphinic acids, organic phosphonic acids, phenols, enols, thiols, acid imides, oximes, and sulfonamides.

Examples of the carboxylic acid include: monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids such as oxalic acid, malonic acid, maleic acid, methylmalonic acid, fumaric acid, adipic acid, sebacic acid, phthalic acid, and tartaric acid; and also include carboxylic acids having three or more carboxy groups, such as citric acid.

Examples of the sulfonic acid include benzenesulfonic acid and p-toluenesulfonic acid.

Examples of the sulfinic acid include benzenesulfinic acid and p-toluenesulfinic acid.

Examples of the organic phosphinic acid include diethylphosphinic acid, methylphenylphosphinic acid, and diphenylphosphinic acid.

Examples of the organic phosphonic acid include methylphosphonic acid, ethylphosphonic acid, t-butylphosphonic acid, cyclohexylphosphonic acid, and phenylphosphonic acid.

Examples of the phenols include: monohydric phenols such as phenol, cresol, 2,6-xylenol, and naphthol; dihydric phenols such as catechol, resorcinol, hydroquinone, and 1,2-naphthalenediol; and trihydric or higher phenols such as pyrogallol and 2,3,6-naphthalenetriol.

Examples of the enol include 2-hydroxy-3-methyl-2-butene and 3-hydroxy-4-methyl-3-hexene.

Examples of the thiol include mercaptoethanol and mercaptopropanol.

Examples of the acid imide include carboxylic acid imide such as maleimide and succinimide, and also include sulfonic acid imide such as di(trifluoromethanesulfonyl)imide and di(pentafluoroethanesulfonyl)imide.

Examples of the oxime include aldoximes such as benzaldoxime and salicylaldoxime, and also include ketoximes such as diethyl ketoxime, methyl ethyl ketoxime, and cyclohexanone oxime.

Examples of the sulfonamide include methylsulfonamide, ethylsulfonamide, benzenesulfonamide, and toluenesulfonamide.

The organic acid (a) is preferably a carboxylic acid having 1 to 10 carbon atoms.

Examples of the hydroxy acid ester include a glycolate ester, a lactate ester, a 2-hydroxycyclohexane-1-carboxylate ester, and a salicylate ester.

Examples of the β-diketone include 2,4-pentanedione, 3-methyl-2,4-pentanedione, and 3-ethyl-2,4-pentanedione.

Examples of the β-keto ester include an acetoacetate ester, an α-alkyl-substituted acetoacetate ester, a β-keto pentanoate ester, a benzoylacetate ester, and a 1,3-acetonedicarboxylate ester.

Examples of the amine compound include pyridine, trimethylamine, piperidine, diethanolamine, and triethanolamine.

Examples of the compound having an amide include a compound having unsubstituted amide (NH₂), methylamide (NHMe), dimethylamide (NMe₂), diethylamide (NEt₂), dipropylamide (NPr₂), etc.

Examples of the compound having an olefin include: chain olefins such as ethylene and propylene; and cyclic olefins such as cyclopentene, cyclohexene, and norbornene.

Examples of the hydrocarbon having a π-bond include: chain dienes such as butadiene and isoprene; cyclic dienes such as cyclopentadiene, methylcyclopentadiene, pentamethylcyclopentadiene, cyclohexadiene, and norbornadiene; and aromatic hydrocarbons such as benzene, toluene, xylene, hexamethylbenzene, naphthalene, and indene.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, and 1,1'-bis(diphenylphosphino)ferrocene.

Examples of the metal compound (M) include compounds represented by the following formula (M-1). Using the metal compound (M-1) as above can form the stable metal compound (M) and can improve the dry-etching resistance:

**LₐM(=O)_{b}X_{c}** **(M-1)**

wherein M represents any of titanium, chromium, manganese, iron, cobalt, nickel, copper, zinc, zirconium, molybdenum, indium, tin, hafnium, tantalum, tungsten, and bismuth. L represents a monodentate ligand and a polydentate ligand having 1 to 30 carbon atoms; and X represents a hydrolysable group selected from a halogen atom, an alkoxy group, a carboxylate group, an acyloxy group, and -NR^{a}R^{b}. R^{a} and R^{b} each independently represent a hydrogen atom or a monovalent organic group having 1 to 20 carbon atoms. a+c = 1 to 6, "a" represents an integer of 0 to 4, "b" represents an integer of 0 to 2, and "c" represents an integer of 0 to 6.

Examples of the hydrolysable group X in the formula (M-1) include a halogen atom, an alkoxy group, a carboxylate group, an acyloxy group, and -NR^{a}R^{b}. R^{a} and R^{b} each independently preferably represent a hydrogen atom or a monovalent organic group having 1 to 20 carbon atoms.

Examples of the halogen atom include a fluorine atom, a chlorine atom, a bromine atom, and an iodine atom.

Examples of the alkoxy group include a methoxy group, an ethoxy group, a n-propoxy group, an i-propoxy group, a n-butoxy group, and a t-butoxy group.

Examples of the carboxylate group include: monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid, and shikimic acid; dicarboxylic acids such as oxalic acid, malonic acid, maleic acid, methylmalonic acid, fumaric acid, adipic acid, sebacic acid, phthalic acid, and tartaric acid, and also include ligands derived from carboxylic acids, etc. having three or more carboxy groups, such as citric acid.

Examples of the acyloxy group include an acetoxy group, an ethylyloxy group, a propionyloxy group, a butylyloxy group, a t-butylyloxy group, a t-amilyloxy group, a n-hexanecarbonyloxy group, and a n-octanecarbonyloxy group.

Examples of the -NR^{a}R^{b} include an unsubstituted amino group, a methylamino group, a dimethylamino group, a diethylamino group, and a dipropylamino group.

The hydrolysable group X is preferably an alkoxy group, and specifically, an i-propoxy group, a n-butoxy group, or a t-butoxy group is more preferable.

### (Monodentate ligand)

Examples of the monodentate ligand include a hydroxo ligand, an amido ligand, an amine ligand, and an olefin ligand.

Examples of the amido ligand include an unsubstituted amido ligand (NH₂), a methylamido ligand (NHMe), a dimethylamido ligand (NMe₂), a diethylamido ligand (NEt₂), and dipropylamido ligand (NPr₂).

Examples of the amine ligand include pyridine, a trimethylamine ligand, and a piperidine ligand.

Examples of the olefin ligand include: chain olefins such as ethylene and propylene; and cyclic olefins such as cyclopentene, cyclohexene, and norbornene.

### (Polydentate ligand)

Examples of the polydentate ligand include a ligand derived from a hydroxy acid ester, a ligand derived from a β-diketone, a ligand derived from a β-keto ester, a hydrocarbon having a π-bond, and a diphosphine.

Examples of the hydroxy acid ester include a glycolate ester, a lactate ester, a 2-hydroxycyclohexane-1-carboxylate ester, and a salicylate ester.

Examples of the β-diketone include an acetoacetate ester, an α-alkyl-substituted acetoacetate ester, a β-keto pentanoate ester, a benzoylacetate ester, and a 1,3-acetonedicarboxylate ester.

Examples of the β-diketo ester include a malonic acid diester, an α-alkyl-substituted malonic acid diester, an α-cycloalkyl-substituted malonic acid diester, and an α-aryl-substituted malonic acid diester.

Examples of the hydrocarbon having a π-bond include: chain dienes such as butadiene and isoprene; cyclic dienes such as cyclopentadiene, methylcyclopentadiene, pentamethylcyclopentadiene, cyclohexadiene, and norbornadiene; and aromatic hydrocarbons such as benzene, toluene, xylene, hexamethylbenzene, naphthalene, and indene.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, and 1,1'-bis(diphenylphosphino)ferrocene.

The monodentate ligand and the polydentate ligand may have a crosslinking group. As the crosslinking group, the ligand preferably has any of a vinyl group, an allyl group, an allyloxy group, an ethynyl group, a propargyl group, a propargyloxy group, an epoxy group, and an oxetanyl group. By using the metal compound having the ligand as described above, the metal-containing film having excellent thermal curability can be formed.

In addition, the metal compound (M) may be a compound including, for example, anions of an oxo acid (such as a phosphate ion, a sulfate ion, a chromate ion, a tungstate ion (WO₄²⁻), and a molybdate ion (MoO₄²⁻)), inorganic anions such as a polyacid anion in which a plurality of oxo acids are condensed, and a mixture thereof.

The polyacid may be an isopolyacid anion (Mm'On')^{c-}or a heteropolyacid anion (X₁'Mm'On')^{c-}. Among the above ion formulae, M represents a polyatom, X represents a heteroatom, "m'" represents a composition proportion of the polyatom, "n'" represents a composition proportion of the oxygen atom, and "l'" represents a composition proportion of the heteroatom. "c" represents a valency of the ion. Examples of the polyatom M include Mo, W, Ti, and Nb. Examples of the heteroatom X include Si, P, As, S, Fe, and Co. In addition, a counter cation such as Na⁺ and H⁺ may be partially contained.

Among these, preferred is an anion of an inorganic acid having at least one of tungsten (W) and molybdenum (Mo) in terms of excellent heat resistance.

Examples of the polyacid having at least one of tungsten (W) and molybdenum (Mo) include a tungstate ion [W₁₀O₃₂]⁴⁻ and a molybdate ion [Mo₆O₁₉]²⁻, which are isopolyacids; a phosphotungstate ion [PW₁₂O₄₀]³⁻ or [P₂W₁₈O₆₂]⁶⁻, a silicotungstate ion [SiW₁₂O₄₀]⁴⁻, a phosphomolybdate ion [PMo₁₂O₄₀]³⁻. a silicomolybdate ion [SiMo₁₂O₄₀]⁴⁻, a phosphotungstomolybdate ion [PW₁₂₋ₓMoₓO₄₀]³⁻("x" represents an integer of 1 to 11) or [P₂W_{18-y}Mo_{y}O₆₂]⁶⁻("y" represents an integer of 1 to 17), and a silicotungstomolybdate ion [SiW₁₂₋ₓMoₓO₄₀]⁴⁻ ("x" represents an integer of 1 to 11), which are heteropolyacids. The polyacid having at least one of tungsten (W) and molybdenum (Mo) is preferably the heteropolyacid among these in terms of heat resistance and ease of raw material availability, and more preferably the heteropolyacid having phosphorus (P).

Further, any of a phosphotungstomolybdate ion [PW₁₀Mo₂O₄₀]³⁻ or [PW₁₁Mo₁O₄₀]³⁻ and a phosphotungstate ion [PW₁₂O₄₀]³⁻ is further preferable in terms of heat resistance.

The metal compound (M) may be a hydrolyte of the metal compound having a hydrolysable group, a hydrolytic condensate of the metal compound having a hydrolysable group, or a combination thereof. Here, "hydrolytic condensation reaction" refers to a reaction in which the hydrolysable group in the metal compound is hydrolyzed and converted into a hydroxy group (-OH), and the obtained two hydroxy groups (-OH) are dehydrationcondensed to form an ether bond (-O-).

Alternatively, a compound in which the above compounds react with a material that can be the monodentate ligand or the polydentate ligand via a ligand-exchange reaction can also be used. A hydrolytic condensation reaction product of the metal-containing compound having a hydrolysable group or a compound in which a hydrolytic condensation reaction product of the metal-containing compound having a hydrolysable group reacts with a material that can be the monodentate ligand or the polydentate ligand may also be used.

Specific examples of the metal compound (M) include, but are not limited to, the following compounds.

Examples of the compounds containing titanium include diisopropoxybis(2,4-pentanedionato)titanium(IV), tetra-n-butoxytitanium(IV), tetra-n-propoxytitanium(IV), tetraisopropoxytitanium(IV), tri-n-butoxymonostearatotitanium(IV), orthotitanate tetrakis(2-ethylhexyl), dihydroxybis(hydrogenlactato)titanium(IV), titanium(IV) butoxide oligomer, aminopropyltrimethoxytitanium(IV), triethoxymono(2,4-pentanedionato)titanium(IV), tri-n-propoxymono(2,4-pentanedionato)titanium(IV), triisopropoxymono(2,4-pentanedionato)titanium, and di-n-butoxybis(2,4-pentanedionato)titanium(IV).

Examples of the compounds containing chromium include chromium(III) tris(2-ethylhexanoate), tris(2,4-pentanedionato)chromium(III), bis(2,2,6,6-tetramethyl-3,5-heptanedionato)chromium(II), tris(trifluoro-2,4-pentanedionato)chromium(III), chromium(III) pyridine-2-carboxylate, chromium(III) chloride, chromium(II) chloride, and chromium(II) cyclohexanecarboxylate.

Examples of the compounds containing nickel include nickel(II) acetate, nickel chloride, nickel(II) 2-ethylhexanoate, bis(2,4-pentanedionato)nickel(II) hydrate, bis(hexafluoroacetylacetonato)nickel(II), nickel(II) 2-amino-5-methylbenzenesulfonate, and nickel(II) trifluoromethanesulfonate, and also include bis(2,2,6,6-tetramethyl-3,5-heptanedionato)nickel(II) and nickel(II) propionate.

Examples of the compounds containing manganese include tris(2,2,6,6-tetramethyl-3,5-heptanedionato)manganese(III).

Examples of the compounds containing iron include tris(2,2,6,6-tetramethyl-3,5-heptanedionato)iron(III), iron(II) oxocyclohexanecarboxylate, and iron chloride.

Examples of the compounds containing cobalt include dichloro[ethylenebis(diphenylphosphine)]cobalt, cobalt(II) bromide, cobalt(II) acetate, tris(1,3-diphenyl-1,3-propanedione)cobalt(III), and cobalt(II) cyclopentylacetate.

Examples of the compounds containing copper include copper(II) acetate, monobutyl phthalate copper(II) salt, copper(II) acetylacetonate, copper(I) heptanoate, and copper(II) 2-ethylhexanoate.

Examples of the compounds containing zinc include zinc diisopropoxide, zinc(II) acetate, zinc(II) chloride, and zinc(II) 4-vinylbenzoate.

Examples of the compounds containing zirconium include dibutoxybis(ethylacetoacetato)zirconium(IV), din-butoxybis(2,4-pentanedionato)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono (2,4-pentanedionato) zirconium (IV), tri-n-propoxymono (2,4-pentanedionato) zirconium (IV), triisopropoxymono (2,4-pentanedionato) zirconium (IV), tri(3-methacryloxypropyl)methoxyzirconium(IV), tri(3-acryloxypropyl)methoxyzirconium(IV), zirconium(IV) acetate, zirconium(IV) oxyacetate, zirconium(II) bis(2-ethylhexanoate), zirconium(IV) tetra(2-ethylhexanoate), oxozirconium(IV) bis(2-ethylhexanoate), zirconium nitrate, zirconium(IV) chloride, and zirconium(IV) carboxyethylacrylate.

Examples of the compounds containing molybdenum include pentaethoxymolybdenum(V), molybdenum(VI) hexaethoxide, molybdenum(V) isopropoxide, molybdenum(II) acetate dimer, bis(acetylacetonato)oxymolybdenum(IV), bis(2,2,6,6-tetramethyl-3,5-heptanedionato)oxymolybdenum(VI), molybdenum 2-ethylhexanoate, molybdenum(V) chloride, and molybdenum(III) chloride.

Examples of the compounds containing indium include tris(1,3-diphenyl-1,3-propanedione)indium(III), indium(III) ethylbutyrate, indium(III) acetate, and triisopropoxyindium(III).

Examples of the compounds containing tin include tin(II) acetate, tin(IV) acetate, tin(II) acetylacetonate, tin(IV) tert-butoxide, tin tetra-n-butoxide, tin tetraisopropoxide, tin(II) 4-fluorobenzeneacetate, and tin(II) 2-ethylhexanoate.

Examples of the compounds containing hafnium include diisopropoxybis(2,4-pentanedionato)hafnium(IV), tetrabutoxyhafnium(IV), tetraisopropoxyhafnium(IV), tetraethoxyhafnium(IV), dichlorobis(cyclopentadienyl)hafnium(IV), hafnium(IV) chloride, tetrakis(dimethylamido)hafnium(IV), tetrakis(ethylmethylamido)hafnium(IV), hafnium carboxyethylacrylate, bis(cyclopentadienyl)hafnium(IV) dichloride, hafnium(IV) trifluoromethanesulfonate hydrate, and hafnium(IV) carboxyethylacrylate.

Examples of the compounds containing tantalum include tantalum(V) methoxide, tantalum(V) ethoxide, tetrabutoxytantalum(IV), pentabutoxytantalum(V), pentaethoxytantalum(V), tantalum(V) chloride, pentakis(dimethylamino)tantalum(V), tris(diethylamido)(tert-butylimido)-tantalum(V), and tantalum(II) bis(2-ethylhexanoate).

Examples of the compounds containing tungsten include tungsten(VI) ethoxide, tetrabutoxytungsten(IV), pentabutoxytungsten(V), pentamethoxytungsten(V), hexabutoxytungsten(VI), hexaethoxytungsten(VI), and dichlorobis(cyclopentadienyl)tungsten(IV).

Examples of the compounds containing bismuth include bismuth(III)-n-butoxide, tri-t-amyloxybismuth(III), triethoxybismuth(III), bismuth(III) tris(β-diketonato), bismuth(III) neodecanoate, tris(2-naphthol)bismuth(III), bismuth(III) fluoride, bismuth(III) bromide, bismuth(III) iodide, bismuth(III) oxychloride, bismuth(III) acetate, bismuth(III) subsalicylate, bismuth(III) 2-ethylhexanoate, and bismuth(III) trifluoromethanesulfonate.

### [(D) Solvent]

A solvent (D) usable in the composition for forming a metal-containing film for which the present invention is applied is not particularly limited as long as it dissolves the metal compound (M) described above and other additive contained, etc.

As specific examples of the solvent (D), organic solvents described in paragraphs [0091] to [0092] in JP 2007-199653 A may be added. Further specifically, propylene glycol monomethyl ether acetate, propylene glycol monomethyl ether, propylene glycol monoethyl ether, propylene glycol monopropyl ether, 2-heptanone, or a mixture containing one or more thereof is preferably used.

Examples of other usable solvents include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclopentanone, cyclohexanone, γ-butyrolactone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, methyl isobutyl ketone, and cyclopentyl methyl ether.

A blending amount of the solvent (D) is preferably within a range of 200 to 10,000 parts, and more preferably 250 to 5,000 parts relative to 100 parts by mass of the metal compound (M).

### <Other additives>

The composition for forming a metal-containing film may contain at least one or more selected from a crosslinker (E), an acid generator (F), and a surfactant (G) according to its application.

Hereinafter, components that can be contained in the composition for forming a metal-containing film other than the metal compound (M) and the solvent (D) will be described.

### [(E) Crosslinker]

When the composition for forming a metal-containing film is used for a resist underlayer film, a crosslinker (E) may be added to increase curability and to further inhibit intermixing with the resist upper layer film. The crosslinker is not particularly limited, and known various types of crosslinkers may be widely used. An example of the crosslinker includes a melamine-type crosslinker, a glycoluril-type crosslinker, a benzoguanamine-type crosslinker, a urea-type crosslinker, a β-hydroxyalkylamide-type crosslinker, an isocyanurate-type crosslinker, an aziridine-type crosslinker, an oxazoline-type crosslinker, an epoxy-type crosslinker, and a phenol-type crosslinker. The crosslinker (E) may be used singly or in combination of two or more thereof. An addition amount of the crosslinker (E) if added is preferably 5 to 50 parts, and more preferably 10 to 40 parts relative to 100 parts of the metal compound (M). The addition amount of 5 parts or more can exhibit sufficient curability to inhibit intermixing with the resist upper layer film. Meanwhile, the addition amount of 50 parts or less cause no risk of deterioration in the dry-etching resistance due to decrease in the proportion of the metal compound (M) in the composition.

Specific examples of the melamine-type crosslinker include hexamethoxymethylmelamine, hexabutoxymethylmelamine, alkoxy- and/or hydroxy-substituted derivatives thereof, and partially self-condensed products thereof.

Specific examples of the glycoluril-type crosslinker include tetramethoxymethylglycoluril, tetrabutoxymethylglycoluril, alkoxy- and/or hydroxy-substituted derivatives thereof, and partially self-condensed products thereof.

Specific examples of the benzoguanamine-type crosslinker include tetramethoxymethylbenzoguanamine, tetrabutoxymethylbenzoguanamine, alkoxy- and/or hydroxy-substituted derivatives thereof, and partially self-condensed products thereof.

Specific examples of the urea-type crosslinker include dimethoxymethyldimethoxyethylene urea, alkoxy- and/or hydroxy-substituted derivatives thereof, and partially self-condensed products thereof.

Specific examples of the β-hydroxyalkylamide-type crosslinker include N,N,N',N'-tetra(2-hydroxyethyl)adipamide.

Specific examples of the isocyanurate-type crosslinker include triglycidylisocyanurate and triallylisocyanurate.

Specific examples of the aziridine-type crosslinker include 4,4'-bis(ethyleneiminocarbonylamino)diphenylmethane and 2,2-bishydroxymethylbutanol-tris[3-(1-aziridinyl)propionate].

Specific examples of the oxazoline-type crosslinker include 2,2'-isopropylidenebis(4-benzyl-2-oxazoline), 2,2'-isopropylidenebis(4-phenyl-2-oxazoline), 2,2'-methylenebis-4,5-diphenyl-2-oxazoline, 2,2'-methylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer.

Specific examples of the epoxy-type crosslinker include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-type crosslinker include compounds represented by the following general formula (10): 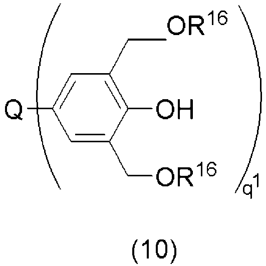 wherein Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

In the general formula (10), Q represents a single bond or a q¹-valent hydrocarbon group having 1 to 20 carbon atoms. "g¹" represents an integer of 1 to 5, and more preferably 2 or 3. Specific examples of Q include groups composed of methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an icosanyl group; and preferred is a hydrogen atom or a methyl group.

The compound represented by the general formula (10) is preferably hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene, from the viewpoint of improvement of the curability and uniformity of the film thickness.

### [(F) Acid generator]

The composition for forming a metal-containing film of the present invention may contain an acid generator (F), and may contain, for example, a compound that generates an acid by sensitization with active ray or radiation (photoacid generator). The photoacid generator may be any compound that generates an acid by high-energy ray irradiation. Examples of a preferable photoacid generator include sulfonium salts, iodonium salts, sulfonyldiazomethanes, N-sulfonyloxyimides, and oxime-O-sulfonate-type acid generators. The composition for forming a metal-containing film of the present invention may also contain a thermal acid generator, which generates an acid by heat. Specific examples of the acid generator include those described in paragraphs [0122] to [0142] in JP 2008-111103 A, and JP 2009-080474 A, and JP 2015-026064 A, for example.

The acid generator (F) may be used singly, or in combination of two or more thereof. An addition amount of the acid generator when added is preferably 0.05 to 50 parts by mass, and more preferably 0.1 to 10 parts by mass relative to 100 parts by mass of the metal compound (M) .

### [(G) Surfactant]

Into the composition for forming a metal-containing film, a surfactant (G) may be added to increase coatability in spin coating. As the surfactant, those described in [0142] to [0147] in JP 2009-269953 A may be used, for example. An addition amount of the surfactant (G) when added is preferably 0.01 to 10 parts by mass, and more preferably 0.05 to 5 parts by mass relative to 100 parts by mass of the metal compound (M).

### [Applying step]

In the applying step, this composition for forming a metal-containing film is applied directly or indirectly onto the substrate. A method for applying the composition for forming a metal-containing film is not particularly limited, and the applying can be performed by an appropriate method such as spin coating, cast coating, and roll coating, for example. The coating film is formed by this step, and the metal-containing film is formed by evaporating the solvent (D), etc.

The substrate onto which the composition for forming a metal-containing film is to be applied is not particularly limited, and a substrate such as Si, α-Si, p-Si, SiO₂, SiN, SiON, W, TiN, and Al, a material in which a layer to be processed is formed on the substrate, etc. are used. As the layer to be processed, various low-k films such as Si, SiO₂, SiON, SiN, p-Si, α-Si, W, W-Si, Al, Cu, and Al-Si, and stopper films thereof are used. The layer to be processed can be formed to have a thickness of typically 50 to 10,000 nm, and specifically 100 to 5,000 nm. Note that, when the layer to be processed is formed, the substrate and the layer to be processed having different materials are used.

A lower limit value of an average thickness of the formed metal-containing film is preferably 3 nm, more preferably 5 nm, and further preferably 10 nm. An upper limit value of the average thickness is preferably 500 nm, more preferably 200 nm, and further preferably 60 nm. Note that a method for measuring the average thickness will be described in Examples.

The method for manufacturing the substrate preferably further includes a step (hereinafter, also referred to as "heating step") of heating a coating film formed by the above applying step. Heating the coating film enhances formation of the metal-containing film. In more detail, heating the coating film enhances evaporation of the solvent (D), etc.

The coating film is heated under the atmosphere typically, but may be heated under a nitrogen atmosphere. A lower limit of temperature in the heating is preferably 150°C, and more preferably 200°C. An upper limit of the temperature is preferably 600°C, and more preferably 500°C. A lower limit of a time of the heating is preferably 15 seconds, and more preferably 30 seconds. An upper limit of the time is preferably 1,200 seconds, and more preferably 600 seconds.

### [Washing step]

In this step, the circumferential edge of the substrate is washed with a washing liquid. As the washing liquid, the aforementioned washing liquid can be suitably used.

The washing method is not particularly limited, and washing methods known in semiconductor manufacturing process, such as edge-bead removal and back rinse, may be adopted. In the present invention, the step of washing the substrate on which the metal-containing film is formed preferably includes: applying the washing liquid of the present invention along the circumferential edge of the substrate; and removing an edge bead on this substrate (hereinafter, which may be referred to as "edge rinse").

In typical, the substrate on which the metal-containing film is formed is rotated at a predetermined rate. Then, a washing-liquid discharging nozzle is moved at a predetermined rate from the outer circumferential end of the rotating substrate toward the center of the substrate while discharging the washing liquid through the washing-liquid discharging nozzle. The motion is stopped when the washing-liquid discharging nozzle has been moved with a predetermined distance, and the washing liquid is further discharged for a predetermined time. Thereafter, discharging of the washing liquid through the washing-liquid discharging nozzle is stopped, and drying is performed as necessary to complete the washing. The rotation rate of the substrate, the discharging amount of the washing liquid per unit time, the moving rate and the moving distance of the washing-liquid discharging nozzle, the discharging time of the washing liquid after motion of the washing-liquid discharging nozzle is stopped, etc. are appropriately set depending on a substrate size, a number, a type, and a thickness of the formed films, a washing area, etc.

The number of times of the edge rinse is not particularly limited, and the edge rinse may be performed once to 20 times. Further, two or more types of the washing liquid may be applied during the edge rinse.

In the edge rinse, the washing liquid may be dropped at an amount of preferably 0.05 to 50 ml, more preferably 0.075 to 40 ml, and further preferably 0.1 to 30 ml.

After this composition for forming a metal-containing film is applied onto the substrate, the washing step can be performed with or without passing through the above heating step. When the washing step is performed after the applying step without passing through the heating step, the heating step is preferably performed after the washing step.

The metal-containing film formed by the above step is preferably any of the photoresist film or the resist underlayer film.

In addition, the washing liquid of the present invention may be also used for reworking the metal-containing film on the substrate to reuse the substrate. The washing-liquid discharging nozzle is moved to the center of the substrate, and the washing liquid is discharged onto the rotating substrate for a predetermined time. Thereafter, discharging the washing liquid through the washing-liquid discharging nozzle is stopped, and drying is performed as necessary to complete the washing. The rotation rate of the substrate, the discharging amount of the washing liquid per unit time, the position for discharging the washing liquid, etc. are appropriately set depending on a substrate size, a number, a type, and a thickness of the formed films, a washing area, etc.

To evaluate the metal removability by the edge rinse, residual metal on the substrate can be inspected. Commercially available appropriate approaches to evaluate trace metal typically include inductively coupled plasma mass spectrometry (ICP-MS). To evaluate the substrate surface, vapor phase decompositioninductively coupled plasma mass spectrometry (VPD-ICP-MS) may be used. The residual metal can be determined per unit area of the wafer surface along the edge by using this technique.

When the metal-containing film is Zr-based in the method for washing a substrate of the present invention, an amount of the residual Zr is preferably 100×10¹⁰ atom/cm² or less, more preferably 50×10¹⁰ atom/cm² or less, further preferably 10×10¹⁰ atom/cm² or less, and particularly preferably 5×10¹⁰ atom/cm² or less.

### [Method for forming metal-containing film]

The method for forming a metal-containing film of the present invention includes: a step of applying a composition for forming a metal-containing film directly or indirectly onto a substrate by using a composition containing a metal compound (M) and a solvent (D) as the composition for forming a metal-containing film; and a step of washing a circumferential edge of the substrate by using the aforementioned washing liquid.

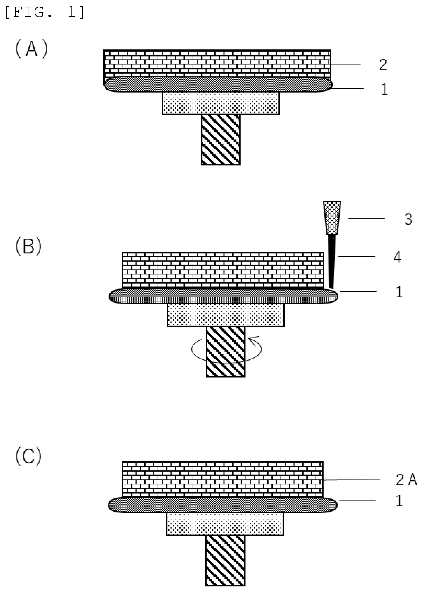

Next, embodiments of the present invention will be described by using FIG. 1 to FIG. 3. Note that the washing method of the present invention is not limited to these examples, and can be performed by a method other than these washing methods.

First, as the first aspect of the present invention, a method for removing the film on the outer circumferential end by using the washing liquid of the present invention will be described regarding FIG. 1.

In the first aspect of the present invention (FIG. 1), (A) a substrate to be processed (1) on which a metal-containing film (2) is formed is disposed on a spin coater. Subsequently, (B) the spin coater is rotated at a predetermined rate, and while discharging a washing liquid (4) of the present invention through a washing-liquid discharging nozzle (3) disposed near the outer circumferential end, the film on the outer circumferential end is removed. Thereafter, drying is performed as necessary to obtain a metal-containing film on which the film on the outer circumferential end is removed (2A), illustrated in (C).

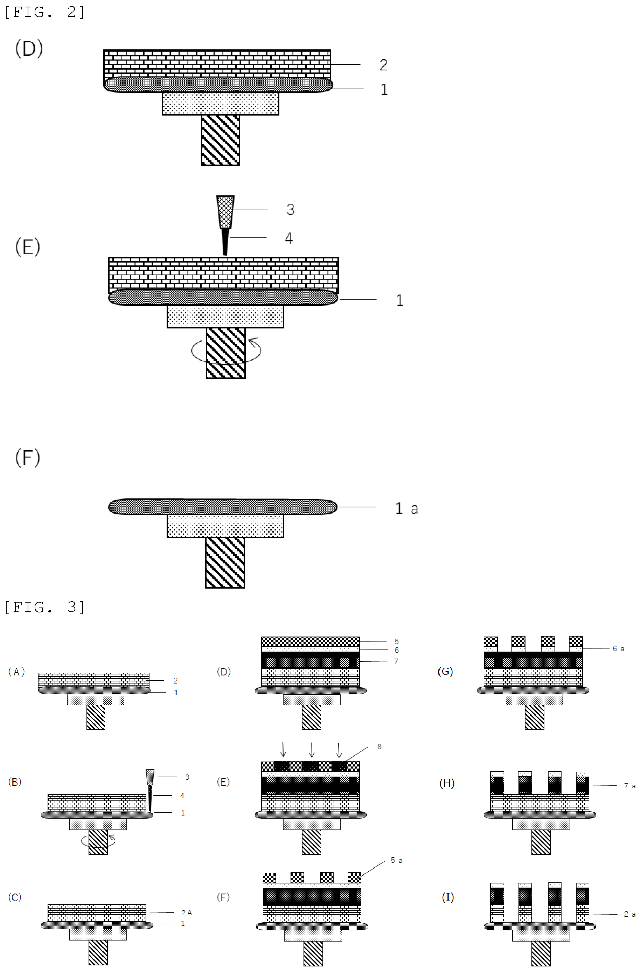

In addition, as the second aspect of the present invention, a method for peeling the metal-containing film by using the washing liquid of the present invention will be described regarding FIG. 2.

In the second aspect of the present invention (FIG. 2), (D) a substrate to be processed (1) on which a metal-containing film (2) is formed is disposed on a spin coater. Subsequently, (E) the spin coater is rotated at a predetermined rate, the washing-liquid discharging nozzle (3) is moved to the center of the substrate to be processed (1), a washing liquid (4) is discharged onto the rotating substrate to be processed (1) for a predetermined time, then discharging the washing liquid (4) through the washing-liquid discharging nozzle (3) is stopped, and drying is performed as necessary to obtain a substrate to be processed on which the metal-containing film is peeled (1a), illustrated in (F).

In addition, as the third aspect of the present invention, a method for forming a metal-containing film pattern of the present invention will be described regarding FIG. 3.

In the third aspect of the present invention (FIG. 3), (A) a substrate to be processed (1) on which a metal-containing film (2) is formed is disposed on a spin coater. Subsequently, (B) the spin coater is rotated at a predetermined rate, and while discharging a washing liquid (4) of the present invention through a washing-liquid discharging nozzle (3) disposed near the outer circumferential end, the film on the outer circumferential end is removed. Thereafter, drying is performed as necessary to obtain (C) a metal-containing film on which the film on the outer circumferential end is removed (2A). Then, (D) an organic resist underlayer film (7) is formed on the substrate to be processed, a silicon-containing resist middle film (6) is formed thereon as a resist middle film, and an organic photoresist film is formed thereon as a resist upper layer film (5). Thereafter, (E) exposure and development are performed, and an unnecessary resist upper layer film (5b) is removed to obtain (F) a resist upper layer film (5a) on which a pattern is formed. Thereafter, (G) a pattern is transferred by dry etching with fluorine-type gas plasma to obtain a silicon-containing resist middle film on which the pattern is formed (6a), (H) the pattern is transferred by dry etching with oxygen-type or hydrogen-type gas plasma to obtain an organic resist underlayer film on which the pattern is formed (7a), and to subsequently obtain (I) a metal-containing film on which the pattern is formed (2a).

### Example

Hereinafter, the present invention will be specifically described with showing Synthesis Examples, Examples, and Comparative Examples, but the present invention is not limited thereto.

### <(B) Compound>

### [(B) Compounds (b-1) to (b-4)]

For a chelating agent (a compound) used for preparing a washing liquid, compounds represented by the following formulae (b-1) to (b-4) were used.

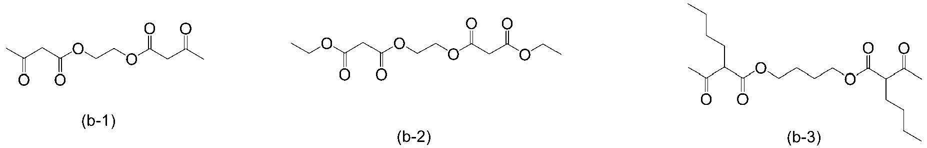

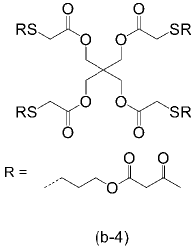

### [Synthesis Example 1] Synthesis of compound (b-1)

Under a nitrogen atmosphere, 60.0 g of tert-butyl acetoacetate, 11.8 g of ethylene glycol, and 50 g of o-xylene were added, and a reaction was performed at an internal temperature of 140°C for 2 hours while removing t-butyl alcohol generated by an ester exchange reaction from the system, and then the temperature was raised to the internal temperature of 160°C while removing t-butyl alcohol and o-xylene from the system to perform the reaction at an internal temperature of 160°C for 6 hours. Into the residue, 300 g of propylene glycol monomethyl ether acetate (PGMEA) was added to form a homogeneous solution, then water and the low boiling-point solvent were distilled off, and further, the concentration was adjusted to recover a compound (b-1) as a PGMEA solution at a concentration of 50%.

### [Synthesis Example 2] Synthesis of compound (b-2)

A compound (b-2) was recovered as a PGMEA solution at a concentration of 50% in the same manner as in the Synthesis Example 1 except that tert-butyl acetoacetate in Synthesis Example 1 was changed to 71.5 g of tert-butyl ethyl malonate.

### [Synthesis Example 3] Synthesis of compound (b-3)

A compound (b-3) was recovered as a PGMEA solution at a concentration of 50% in the same manner as in the Synthesis Example 1 except that: tert-butyl acetoacetate in Synthesis Example 1 was changed to 60.0 g of tert-butyl 2-butylacetoacetate; and ethylene glycol was changed to 12.6 g of 1,4-butanediol.

### [Synthesis Example 4] Synthesis of compound (b-4)

Under a nitrogen atmosphere, 20.0 g of pentaerythritol tetrathioglycolate, 27.0 g of allyl acetoacetate, and 200 g of tetrahydrofuran (THF) were added to form a homogeneous solution at an internal temperature of 50°C. Thereafter, 1.1 g of dimethyl 2,2'-azobis(isobutyrate) was added to form a homogeneous solution, and then a reaction was performed at an internal temperature of 60°C for 24 hours. After the reaction was finished, the mixture was cooled to room temperature, 500 ml of hexane was added into the reaction liquid to precipitate the reaction product to an underlayer as a viscous liquid. The supernatant layer separated by leaving to stand the mixture at room temperature for a while was removed by decantation. Into the residue, 300 g of propylene glycol monomethyl ether acetate (PGMEA) was added to form a homogeneous solution, then water and the low boiling-point solvent were distilled off, and further, the concentration was adjusted to recover a compound (b-4) as a PGMEA solution at a concentration of 50%.

For Comparative Example chelating agents (R-1) to (R-2), the following compounds were used.
(R-1): Acetylacetone
(R-2): Dimethyl malonate

### <Preparation of washing liquid> (Examples 1-1 to 1-6 and Comparative Examples 1-1 to 1-3)

The components were mixed at a ratio shown in Table 1 to prepare each washing liquid.

For a solvent, propylene glycol methyl ether acetate (PGMEA) was used.

**[Table 1]**

| Washing liquid | Acid (A) | Compound (B) | | Solvent (C) |
|---|---|---|---|---|
| | Type (parts by mass) | Structure | (parts by mass) | Type (parts by mass) |
| MER-1 | Acetic acid (30) | b-1 | (1) | PGMEA(69) |
| MER-2 | Formic acid (30) | b-1 | (1) | PGMEA(69) |
| MER-3 | Citric acid (30) | b-1 | (1) | PGMEA(69) |
| MER-4 | Acetic acid (30) | b-2 | (1) | PGMEA(69) |
| MER-5 | Formic acid (30) | b-3 | (1) | PGMEA(69) |
| MER-6 | Citric acid (30) | b-4 | (1) | PGMEA(69) |
| Comparative Example MER-1 | Acetic acid (30) | R-1 | (1) | PGMEA(69) |
| Comparative Example MER-2 | Acetic acid (30) | R-2 | (1) | PGMEA(69) |
| Comparative Example MER-3 | Acetic acid (30) | - | - | PGMEA(70) |

### <Preparation of composition for forming metal-containing film>

### [Synthesis Examples of metal compound]

In the following Synthesis Examples, metal sources M: (M1) to (M3) and compound group H: (H1) to (H3) shown below was used.
(M1): Ti(OBu)₄: Tetrabutyl orthotitanate (Tokyo Chemical Industry Co., Ltd., B0742)
(M2): Hf(OBu)₄: Hafnium (IV) n-butoxide (Sigma-Aldrich Corp., 667943)
(M3): Zr(OBu)₄: Zirconium (IV) tetrabutoxide (80 mass% 1-butanol solution) (Tokyo Chemical Industry Co., Ltd., Z0016)

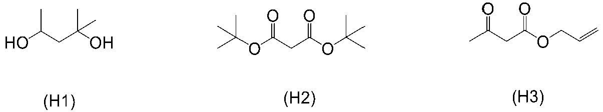

### [Synthesis Example 5] Synthesis of metal compound (m-1) for forming metal-containing film

Under a nitrogen atmosphere, while stirring 40.5 g of a n-butanol solution of 28.4 g of tetrabutyl orthotitanate (M1), 54.5 g of a n-butanol solution of 1.6 g of deionized water was added dropwise thereinto at room temperature over 2 hours. Into the obtained solution, 9.9 g of the compound group (H1) was added, and the mixture was stirred at room temperature for 30 minutes. This solution was condensed at 30°C under a reduced pressure, then further heated to 60°C, and heating was continued under a reduced pressure until no distillate was generated. When no distillate was generated, 69.0 g of a PGMEA/PGME (weight ratio: 70/30) solution was added, and the mixture was heated at 40°C under a reduced pressure until n-butanol was not distilled to obtain a PGMEA/PGME solution of a metal compound (m-1) for forming a metal-containing film. A concentration of the components in the solution other than the solvent was 17 mass%.

### [Synthesis of compounds (m-2) and (m-3)]

Compounds (m-2) and (m-3) shown in Table 2 were obtained under the same reaction condition as of Synthesis Example 1 except that the metal source M and the compound group H were used at the feeding amounts shown in Table 2.

**[Table 2]**

| Synthesis Example | Metal raw material | | Compound group H | | Compound |
|---|---|---|---|---|---|
| | Raw material | g | Raw material | g | |
| 1 | M1 | 28.4 | H1 | 9.9 | m-1 |
| 2 | M2 | 54.9 | H2 | 25.2 | m-2 |
| 3 | M3 | 57.5 | H3 | 17.0 | m-3 |

### [Preparation of compound (m-4)]

For the metal compound (m-4), tin(II) 2-ethylhexanoate (Tokyo Chemical Industry Co., Ltd., T3149) was used.

### [Preparation of composition (MUL-1) for forming metal-containing film]

The compound (m-1) for forming a metal-containing film was dissolved in a mixed solvent of propylene glycol monomethyl ether acetate (PGMEA) and propylene glycol monomethyl ether (PGME) at a ratio shown in Table 3, and the mixture was filtered with a membrane filter of 0.02 µm to prepare a composition (MUL-1) for forming a metal-containing film.

### [Preparation of compositions (MUL-2 to 4) for forming metal-containing film]

Each of chemical reagents was prepared in the same manner as of MUL-1 except that the type and content of each of the components were set as shown in Table 3.

**[Table 3]**

| Composition for forming metal-containing film | Metal compound | | Solvent | |
|---|---|---|---|---|
| | Type | parts by mass | Type | parts by mass |
| MUL-1 | m-1 | 10.0 | PGMEA/PGME | 70/20 |
| MUL-2 | m-2 | 10.0 | PGMEA/PGME | 70/20 |
| MUL-3 | m-3 | 10.0 | PGMEA/PGME | 70/20 |
| MUL-4 | m-4 | 15.0 | PGMEA/PGME | 65/20 |

### <Evaluation of metal washability>

Onto a silicon substrate of 300 mm, the compositions (MUL-1 to 4) for forming a metal-containing film prepared above were applied by spin coating to obtain a coating film. The average film thickness was measured by ellipsometry, Atlax-XP, and found to be 180 nm. On the obtained coating film, 20 ml of the washing liquids (MER-1 to 6 and Comparative Examples MER-1 to 3) were dispensed, left for 30 seconds, then subjected to spin drying, and baked at 100°C for 60 seconds to evaporate the washing liquid. The obtained silicon substrate was cut into 2.0 cm × 3.5 cm to obtain a substrate A for evaluation. The obtained substrate A for evaluation was immersed in a 38%-hydrofluoric acid aqueous solution for 1 minute to obtain a solution A for evaluation in which the metal component was extracted. The obtained solution A for evaluation was analyzed with a double-focusing high-resolution ICP-MS ELEMENT 2, manufactured by Thermo Fischer Scientific K.K.

A solution B for evaluation was obtained in the same manner as that used to obtain the solution A for evaluation except that OK73 thinner was used as the washing liquid instead of the washing liquids (MER-1 to 6 and Comparative Examples 1 to 3). The OK73 thinner is a mixed solvent of propylene glycol monomethyl ether and propylene glycol methyl ether acetate.

As for the metal washability, a case where an amount of metal constituting the metal compound for forming a metal-containing film detected from the solution A for evaluation was less than 30% of that from the solution B for evaluation was evaluated as "A", a case of 30% or more and less than 50% was evaluated as "B", and a case where 50% or more was evaluated as "C". Table 4 shows the results.

**[Table 4]**

| Example | Composition for forming metal-containing film | Washing liquid | Analyte metal | Amount of residual metal |
|---|---|---|---|---|
| Example 1-1 | MUL-1 | MER-1 | Ti | A |
| Example 1-2 | MUL-2 | MER-2 | Zr | A |
| Example 1-3 | MUL-3 | MER-3 | Hf | A |
| Example 1-4 | MUL-4 | MER-4 | Sn | A |
| Example 1-5 | MUL-2 | MER-5 | Zr | A |
| Example 1-6 | MUL-2 | MER-6 | Zr | A |
| Comparative Example 1-1 | MUL-2 | Comparative Example MER-1 | Zr | B |
| Comparative Example 1-2 | MUL-2 | Comparative Example MER-2 | Zr | B |
| Comparative Example 1-3 | MUL-2 | Comparative Example MER-3 | Zr | C |

As shown in Table 4, Examples 1-1 to 1-6 using the washing liquid of the present invention yielded a small amount of the residual metal, and exhibited good results. It was found that the metal washability was excellent because the compound having two or more β-diketone structures in a molecule was used for the chelating agent. Meanwhile, it was found that Comparative Examples 1-1 to 1-3 yielded a large amount of the residual metal, and exhibited poor metal washability.

### <Drainage stability> (Examples 2-1 to 2-6)

The washing liquids (MER-1 to 6) prepared above, the compositions (MUL-1 to 4) for forming a metal-containing film, a composition (SOC-1) for forming a resist underlayer film, a composition (SOG-1) for forming a silicon-containing film, and a photoresist composition (PR-1) were mixed at the same amount to produce a mixed solution, and the mixed solution was left to stand at 23°C for one week to visually check presence or absence of a precipitate and cloudiness. As for the drainage stability, a case where a precipitate and cloudiness were not observed after the produced mixed solution was left to stand at 23°C for one week was evaluated as "Good".

For the composition (SOC-1) for forming a resist underlayer film, a composition (SOG-1) for forming a silicon-containing film, and the photoresist composition (PR-1), the following materials were used.

As for the composition (SOC-1) for forming a resist underlayer film, a polymer shown as a polymer (SOP 1) for an organic underlayer film was dissolved into an organic solvent containing 0.1 mass% of FC-4430 (manufactured by Sumitomo 3M Limited.) at a ratio shown in Table 5, and the mixture was filtered with a filter having a pore diameter of 0.2 µm made of a fluororesin to prepare the composition (SOC-1) for forming a resist underlayer film.

**[Table 5]**

| | Polymer for organic underlayer film | Organic solvent |
|---|---|---|
| | (parts by mass) | (parts by mass) |
| SOC-1 | SOP1(7) | PGMEA(93) |

The structural formula of the polymer (SOP 1) for an organic underlayer film used in this evaluation is shown in Table 6.

**[Table 6]**

| Compound or polymer | Mw | Mw/Mn |
|---|---|---|
| 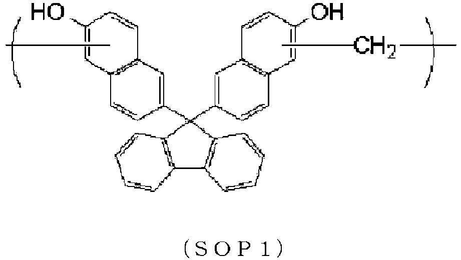 | 3,700 | 2.82 |

### #1 Compound or polymer

As for the composition (SOG-1) for forming a silicon-containing film, a polymer shown as a polymer (SiP 1) for a silicon-containing middle film and a crosslinking catalyst (CAT 1) were dissolved into an organic solvent containing 0.1 mass% of FC-4430 (manufactured by Sumitomo 3M Limited.) at a ratio shown in Table 7, and the mixture was filtered with a filter having a pore diameter of 0.1 µm made of a fluororesin to prepare the composition (SOG-1) for forming a silicon-containing film.

**[Table 7]**

| | Polymer | Thermal crosslinking catalyst | Organic solvent |
|---|---|---|---|
| | (parts by mass) | (parts by mass) | (parts by mass) |
| SOG-1 | SiP1 | CAT1 | Propylene glycol ether monoethyl |
| | (100) | (1) | (4000) |

The structural formulae of the polymer (SiP 1) for a silicon-containing middle film and the crosslinking catalyst (CAT 1) used in this evaluation are shown below.

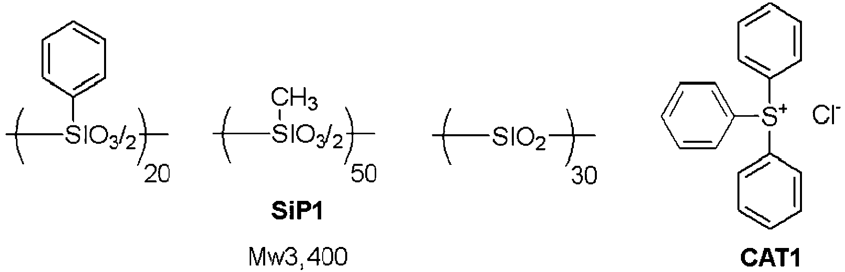

As for the photoresist composition (PR-1), a polymer, a quencher, and a sensitizer, shown below, were dissolved into an organic solvent containing 0.25 mass% of FC-4430 (manufactured by Sumitomo 3M Limited.) at a ratio shown in Table 8, and the mixture was filtered with a filter having a pore diameter of 0.1 µm made of a fluororesin to prepare the photoresist composition (PR-1) . 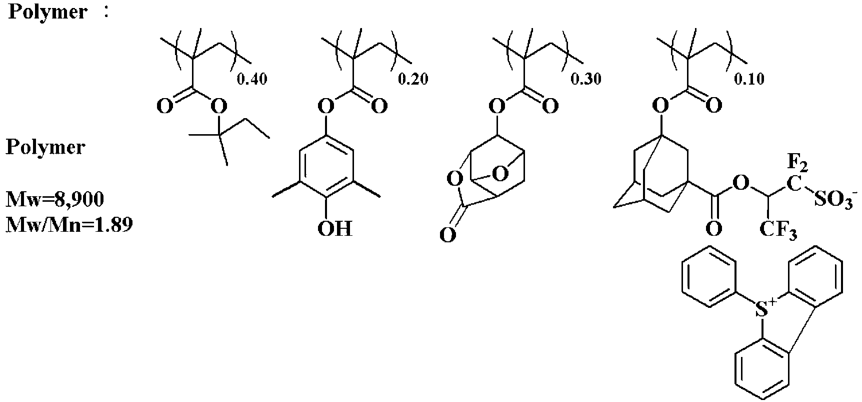 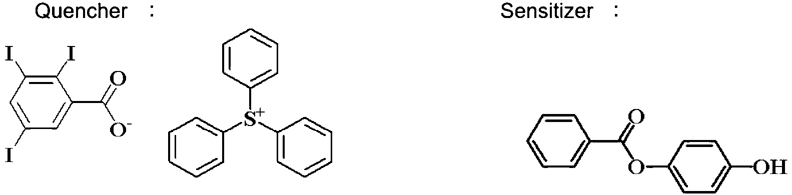 Surfactant: FC-4430, manufactured by 3M Limited.

**[Table 8]**

| Component | Polymer | Quencher | Sensitizer | Surfactant | Organic solvent |
|---|---|---|---|---|---|
| PR-1 (parts by mas) | | | | | PGMEA(400) |
| | (100) | (4.0) | (2.1) | (0.25) | CyHO(2000) |
| | | | | | PGME(100) |

| | |
|---|---|
| Organic solvent: | Propylene glycol monomethyl ether acetate (PGMEA) |
| | Cyclohexanone (CyHO) |
| | Propylene glycol monomethyl ether (PGME) |

**[Table 9]**

| Example | Washing liquid | Composition for forming metal-containing film | | Composition for forming resist underlayer film | | Composition for forming silicon-containing film | | Photoresist composition | |
|---|---|---|---|---|---|---|---|---|---|
| | | Material | Stability | Material | Stability | Material | Stability | Material | Stability |
| Example 2-1 | MER-1 | MUL-1 | Good | SOC-1 | Good | SOG-1 | Good | PR-1 | Good |
| Example 2-2 | MER-2 | MUL-2 | Good | SOC-1 | Good | SOG-1 | Good | PR-1 | Good |
| Example 2-3 | MER-3 | MUL-3 | Good | SOC-1 | Good | SOG-1 | Good | PR-1 | Good |
| Example 2-4 | MER-4 | MUL-4 | Good | SOC-1 | Good | SOG-1 | Good | PR-1 | Good |
| Example 2-5 | MER-5 | MUL-1 | Good | SOC-1 | Good | SOG-1 | Good | PR-1 | Good |
| Example 2-6 | MER-6 | MUL-2 | Good | SOC-1 | Good | SOG-1 | Good | PR-1 | Good |

As shown in the results in Table 9, it was found that Examples (2-1 to 2-6) using the washing liquid of the present invention exhibited excellent drainage stability.

From the above, the washing liquid of the present invention can provide the washing liquid having excellent washability such as removal of the metal-containing film on the circumferential edge of the substrate and having excellent drainage stability when the composition for forming a metal-containing film is applied onto the substrate, by containing the compound having two or more β-diketone structures in a molecule. In addition, the method for washing a substrate and the method for forming a resist underlayer film using this use the washing liquid having excellent washability and drainage stability, and therefore, a desired resist underlayer film can be efficiently formed. These can be suitably used for manufacturing semiconductor devices, etc. in which further fining is expected to proceed in future.

The present description includes the following embodiments.
[1]: A washing liquid for a composition for forming a metal-containing film, the washing liquid comprising:
   (A) an organic acid;
   (B) a compound having two or more β-diketone structures in a molecule; and
   (C) a solvent.
[2]: The washing liquid according to [1], wherein the compound (B) has a structure represented by the following general formula (B-1): 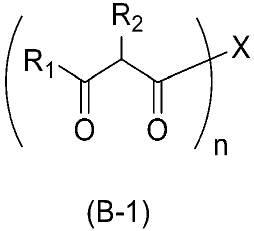 wherein R₁ and R₂ represent a hydrogen atom, a monovalent organic group having 1 to 30 carbon atoms, a thiol group, a hydroxy group, an amino group, a carboxy group, or a halogen atom; X represents an n-valent organic group having 1 to 60 carbon atoms; and "n" represents an integer of 2 to 6.
[3]: The washing liquid according to [2], wherein the compound (B) has a structure represented by the following general formula (B-0a): 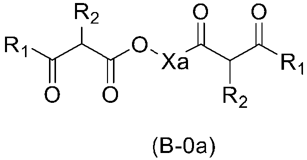
   wherein R₁ and R₂ represent a hydrogen atom, a monovalent organic group having 1 to 30 carbon atoms, a thiol group, a hydroxy group, an amino group, a carboxy group, or a halogen atom; and Xa represents a structure represented by the following general formula (B-1a):

      Xₐ= *¹-W-O-*² (B-1a)
   wherein W represents a divalent organic group, "*¹" represents a point of attachment to an oxygen atom, and "*²" represents a point of attachment to a carbonyl carbon atom in the β-diketone structure.
[4] The washing liquid according to [3], wherein Xa in the general formula (B-0a) represents a structure represented by the following general formula (B-2a): 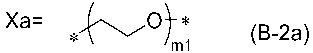 wherein "m₁" represents an average number of repeating units, and represents 1 to 10, and "*" represents a point of attachment.
[5]: The washing liquid according to any one of [1] to [4], wherein the solvent (C) contains at least one or more solvents selected from the group consisting of a ketone solvent and an ester solvent.
[6]: The washing liquid according to any one of [1] to [5], wherein the organic acid (A) is a carboxylic acid.
[7]: The washing liquid according to any one of [1] to [6], wherein a content of the compound (B) is 0.1 to 10 mass% relative to a total mass of the washing liquid.
[8]: The washing liquid according to any one of [1] to [7], wherein a content of the organic acid (A) is 0.5 to 80 mass% relative to a total mass of the washing liquid.
[9]: A method for washing a substrate, the method comprising:
   a step of applying a composition for forming a metal-containing film directly or indirectly onto a substrate; and
   a step of washing the substrate with the washing liquid according to any one of [1] to [8].
[10]: A method for forming a metal-containing film, the method comprising:
   a step of applying a composition for forming a metal-containing film directly or indirectly onto a substrate by using a composition containing a metal compound (M) and a solvent (D) as the composition for forming a metal-containing film; and
   a step of washing a circumferential edge of the substrate by using the washing liquid according to any one of [1] to [8].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A washing liquid for a composition for forming a metal-containing film, the washing liquid comprising:
(A) an organic acid;
(B) a compound having two or more β-diketone structures in a molecule; and
(C) a solvent.

2. The washing liquid according to claim 1, wherein the compound (B) has a structure represented by the following general formula (B-1): 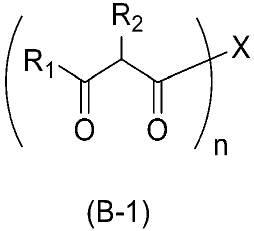 wherein R₁ and R₂ represent a hydrogen atom, a monovalent organic group having 1 to 30 carbon atoms, a thiol group, a hydroxy group, an amino group, a carboxy group, or a halogen atom; X represents an n-valent organic group having 1 to 60 carbon atoms; and "n" represents an integer of 2 to 6.

3. The washing liquid according to claim 2, wherein the compound (B) has a structure represented by the following general formula (B-0a): 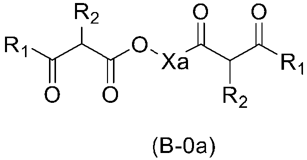
wherein R₁ and R₂ represent a hydrogen atom, a monovalent organic group having 1 to 30 carbon atoms, a thiol group, a hydroxy group, an amino group, a carboxy group, or a halogen atom; and Xa represents a structure represented by the following general formula (B-1a):
Xₐ= *¹-W-O-*² (B-1a)
wherein W represents a divalent organic group, "*¹" represents a point of attachment to an oxygen atom, and "*²" represents a point of attachment to a carbonyl carbon atom in the β-diketone structure.

4. The washing liquid according to claim 3, wherein Xa in the general formula (B-0a) represents a structure represented by the following general formula (B-2a): 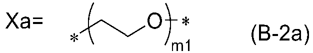 wherein "m₁" represents an average number of repeating units, and represents 1 to 10, and "*" represents a point of attachment.

5. The washing liquid according to any one of claims 1 to 4, wherein the solvent (C) contains at least one or more solvents selected from the group consisting of a ketone solvent and an ester solvent.

6. The washing liquid according to any one of claims 1 to 5, wherein the organic acid (A) is a carboxylic acid.

7. The washing liquid according to any one of claims 1 to 6, wherein a content of the compound (B) is 0.1 to 10 mass% relative to a total mass of the washing liquid.

8. The washing liquid according to any one of claims 1 to 7, wherein a content of the organic acid (A) is 0.5 to 80 mass% relative to a total mass of the washing liquid.

9. A method for washing a substrate, the method comprising:
a step of applying a composition for forming a metal-containing film directly or indirectly onto a substrate; and
a step of washing the substrate with the washing liquid according to any one of claims 1 to 8.

10. A method for forming a metal-containing film, the method comprising:
a step of applying a composition for forming a metal-containing film directly or indirectly onto a substrate by using a composition containing a metal compound (M) and a solvent (D) as the composition for forming a metal-containing film; and
a step of washing a circumferential edge of the substrate by using the washing liquid according to any one of claims 1 to 8.
